(19) Europäisches Patentamt
European Patent Office
Office européen des brevets

(11) **EP 4 300 113 B1**

(12) **FASCICULE DE BREVET EUROPEEN**

(45) Date de publication et mention
de la délivrance du brevet:
**27.11.2024 Bulletin 2024/48**

(21) Numéro de dépôt: **23182068.9**

(22) Date de dépôt: **28.06.2023**

(51) Classification Internationale des Brevets (IPC):
*G01R 31/54* (2020.01)       *H02H 3/32* (2006.01)
*H02H 3/253* (2006.01)       *H02H 5/10* (2006.01)
*H02H 11/00* (2006.01)

(52) Classification Coopérative des Brevets (CPC):
**G01R 31/54; H02H 3/325;** H02H 5/10;
H02H 11/001; H02H 11/002

(54) **DETECTION DE PERTE DE NEUTRE OU DE PHASE**

DETEKTION VON NEUTRAL- ODER PHASENVERLUST

DETECTION OF LOSS OF NEUTRAL OR PHASE

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priorité: **28.06.2022 FR 2206488**

(43) Date de publication de la demande:
**03.01.2024 Bulletin 2024/01**

(73) Titulaire: **Sagemcom Energy & Telecom SAS
92270 Bois-Colombes (FR)**

(72) Inventeurs:
• **LHUILLIER, Pierre
92500 RUEIL MALMAISON (FR)**
• **SAINT-LEGER, Sébastien
92500 RUEIL MALMAISON (FR)**

(74) Mandataire: **Cabinet Boettcher et al
5, rue de Vienne
75008 Paris (FR)**

(56) Documents cités:
**EP-B1- 2 693 227      CN-A- 107 449 979
CN-A- 113 607 994**

**Description**

L'invention concerne le domaine des réseaux de distribution d'énergie électrique et des équipements qui sont connectés auxdits réseaux.

ARRIERE PLAN DE L'INVENTION

Une rupture du conducteur de neutre en amont d'un compteur électrique relève de la responsabilité du fournisseur d'énergie et peut engendrer des problèmes importants sur le matériel électrique de l'installation du client final, située en aval du compteur électrique.

Selon l'impédance présente sur chacun des conducteurs de phase en aval du point de rupture du conducteur de neutre, le déséquilibre des tensions peut être important. Des tensions dangereuses peuvent apparaître et éventuellement détruire le matériel branché chez le client.

Il est donc important de pouvoir détecter de manière fiable et réactive l'apparition d'un évènement de perte de neutre, dans l'optique de prendre des mesures préventives et/ou protectives adéquates.

Outre la détection de la perte du neutre, la détection de la perte d'au moins une phase est également importante, notamment dans le cadre de la maintenance active et réactive du réseau électrique pour en maximiser la qualité.

Traditionnellement, la détection d'une perte de neutre repose sur la détection d'un déséquilibre anormal des tensions simples et/ou d'une absence de courant sur le neutre.

On connaît ainsi une méthode de l'art antérieur, qui vise à détecter une perte de neutre en utilisant un critère de détection basé uniquement sur un constat de déséquilibre anormal des tensions simples. Un tel critère n'est pas suffisamment fiable, notamment car il ne permet pas de discriminer, tout simplement, le cas de la perte du neutre du cas de la perte d'une phase.

On connaît aussi une méthode de l'art antérieur, qui utilise un critère de détection basé sur le courant dans le neutre. Cette méthode nécessite donc d'avoir un élément de mesure de courant sur le neutre, ce qui constitue un surcoût et implique des contraintes fortes d'implémentations physiques et électriques.

On connaît en outre une méthode de l'art antérieur, dont la mise en œuvre implique notamment une mesure des charges avales, afin d'être en mesure de prévoir le déséquilibre des tensions attendu, et de détecter ce déséquilibre lorsque ce cas de figure se produit effectivement.

Cependant, l'effectivité de cette solution est directement liée à la pertinence des impédances avales mesurées, ce qui constitue un point limitant puisque l'analyse théorique proposée considère des charges linéaires et constantes dans le temps, ce qui n'est pas nécessairement le cas dans la réalité pratique du terrain.

De plus, cette méthode repose sur une étude théorique ne concernant qu'un seul compteur. Mais si la coupure de neutre concerne plusieurs compteurs, ayant chacun des charges avales différentes (non corrélées) et déséquilibrées, alors on voit que les compteurs partagent le même neutre flottant, dont le potentiel est fixé par la combinaison de différentes charges avales derrière tous ces compteurs.

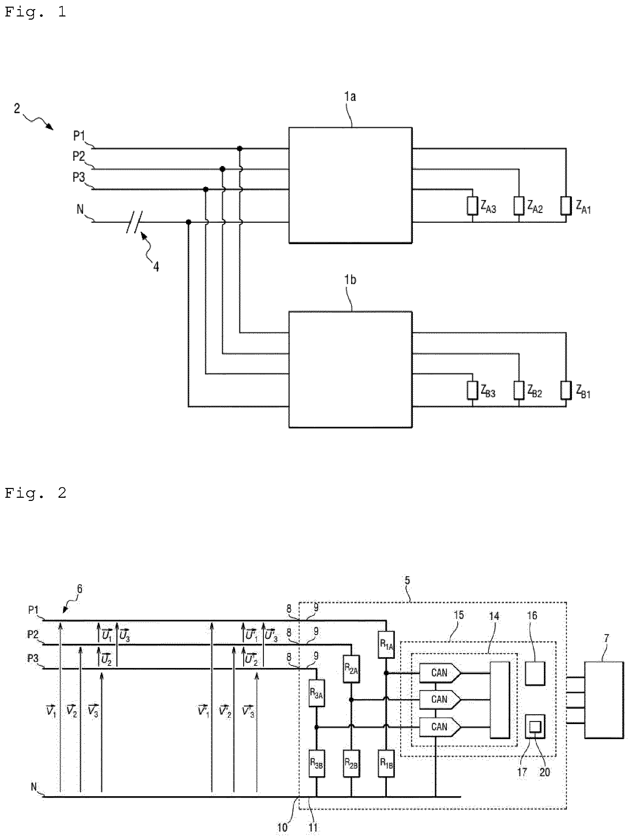

Ce cas de figure est illustré sur la figure 1. On voit que deux compteurs 1a et 1b, reliés à un même réseau électrique 2 comprenant trois phases P1, P2, P3 et un neutre N, sont impactés par la coupure du neutre au point de rupture 4.

La méthode en question ne permet pas de détecter une perte de neutre dans cette configuration. En effet, dans le cas où la coupure de neutre concerne un groupe de compteurs, pour un compteur donné, l'impédance avale estimée ne considère que les charges en aval dudit compteur. Or, la charge effective amenant au déséquilibrage pratique provient de la combinaison de l'ensemble des charges avales de l'ensemble de compteurs de la grappe. Cette approche rend donc impossible la détection de la perte du neutre dans ce cas de figure, puisque la combinaison de l'ensemble des charges avales est inaccessible et donc impossible à estimer pour un compteur donné.

La détection de perte d'une phase est généralement déclarée lorsque la tension simple mesurée pour la phase concernée (entre la phase et le neutre) est en deçà d'un certain seuil prédéterminé. En effet, il est communément admis qu'en cas de perte de phase, la charge en aval du point de rupture « ramène » la tension de phase au neutre, amenant à une mesure de la tension simple à priori proche de 0V.

Mais cette approche simplifiée ne couvre pas tous les cas de figure pratiques susceptibles d'être rencontrés sur le terrain.

En effet, il peut également y avoir des charges entre phases en aval du point de rupture, tant et si bien que la phase devenue flottante s'établit naturellement selon l'équilibre des charges avales (par rapport au neutre, mais aussi par rapport aux phases toujours présentes), l'amenant possiblement à présenter une valeur de tension simple potentiellement élevée (dans l'absolu, elle peut varier entre 0V et Vn, qui est la tension simple nominale du réseau), et donc la détectabilité de la perte d'une phase ne peut pas être établie de manière certaine sur la seule base de la mesure de sa tension simple.

En outre, il peut y avoir conjointement une perte du neutre et une perte d'une phase, et la détection de cette dernière dans ce cas de figure devient plus hasardeuse encore si elle est établie sur la seule base de la mesure de sa tension simple.

On ajoute enfin que certaines méthodes de l'art antérieur, visant à détecter une perte de neutre et/ou de phase(s), ont pour critère la comparaison par rapport à une (ou plusieurs) valeur(s) de référence établie(s) sur la base de mesures réalisées avant l'apparition des ruptures physiques sur les conducteurs.

Cela pose plusieurs problèmes potentiels. Tout d'abord, une fois que la rupture du neutre et/ou de phase (s) a eu lieu, les conditions réelles (tensions) du réseau électrique deviennent inaccessibles à la mesure, et donc les critères de comparaison deviennent figés sur la valeur obtenue au dernier instant avant apparition de la ou des ruptures. S'il est considéré que les tensions d'un réseau électrique sont relativement stables dans le temps, la rupture peut durer aussi suffisamment longtemps pour que les tensions réelles du réseau électrique finissent par différer significativement des dernières mesures connues, rendant les critères de comparaison obsolètes et donc potentiellement rendant les détections moins fiables le temps passant. Ensuite, la perte d'un conducteur (neutre ou phase) peut se produire brutalement, mais peut aussi apparaître lentement, petit à petit, par dérive de l'impédance de ligne jusqu'à ce qu'elle devienne si élevée qu'elle s'apparente à une perte du conducteur. Dans ce cas, l'augmentation progressive de l'impédance de ligne peut s'étaler sur une période temporelle assez étendue (plusieurs secondes, minutes, ...), de sorte que, comme la rupture n'est pas franche, le critère de comparaison (qui se base normalement sur les conditions mesurées sur réseau (tension du réseau) avant rupture du (ou des) conducteur(s)) ne peut plus être clairement établi, rendant la réalisation moins fiable et bien plus hasardeuse.

CN10744997B divulgue une autre méthode de détection d'une perte de neutre dans un réseau polyphasé comprenant une mesure de tensions $U_{a1}$, $U_{a2}$ et $U_{a3}$ pour déterminer des paramètres $U_0$, $I_0$ et $I_{er}$ du réseau. La méthode détermine huit états de connexion et de déconnexion du réseau à partir d'une table de règles floues et à partir des paramètres $U_0$, $I_0$ et $I_{er}$.

OBJET DE L'INVENTION

L'invention a pour objet une méthode permettant de détecter une perte de neutre et/ou d'au moins une phase d'un réseau électrique, qui ne présente pas les inconvénients des méthodes de l'art antérieur qui viennent d'être décrites.

RESUME DE L'INVENTION

En vue de la réalisation de ce but, on propose un procédé de surveillance d'un réseau électrique polyphasé, mis en oeuvre au moins partiellement dans une unité de traitement d'un équipement électrique connecté au réseau électrique polyphasé, et comprenant les étapes, répétées régulièrement, de :

- acquérir des mesures de tensions réalisées par des capteurs de tension de l'équipement électrique qui sont reliés au réseau électrique polyphasé ;
- produire, à partir des mesures de tension, des valeurs courantes de paramètres électriques ;
- accéder à une table de référence, qui comprend une liste de configurations de connexion associées chacune à une combinaison distincte de valeurs de référence desdits paramètres électriques, la liste de configurations de connexion comprenant des premières configurations de connexion correspondant chacune à une combinaison distincte d'états de connexion ou de déconnexion pour chaque phase et pour le neutre ;
- mettre en oeuvre un algorithme exploratoire, destiné à explorer la table de référence pour identifier la configuration de connexion associée aux valeurs courantes des paramètres électriques.

Le procédé de surveillance selon l'invention consiste donc à produire des valeurs courantes de paramètres électriques, qui sont obtenues uniquement à partir de mesures de tensions, puis à explorer une table de référence et à identifier la configuration de connexion qui correspond aux valeurs courantes des paramètres électriques. La table de référence peut contenir des valeurs de référence des paramètres électriques associées à tous les cas de figure possibles : différentes combinaisons d'états de connexion normale ou de coupure pour les lignes, différentes valeurs d'impédances en aval de la coupure, inversion de phase et de neutre, phase déconnectée mais portée au potentiel d'une autre phase, etc.

L'exploration systématique et exhaustive de la table permet de déduire la configuration de connexion de manière très précise et très fiable.

Le procédé de surveillance ne nécessite aucune mesure de courant, et ne nécessite aucune estimation des impédances en aval de la perte du neutre ou d'une phase. Le procédé de surveillance permet en particulier de discriminer le cas de la perte du neutre du cas de la perte d'une phase. Il est fonctionnel quel que soit le nombre de compteurs connectés à la ligne coupée. Il ne nécessite pas d'utiliser des valeurs de référence établies sur la base de mesures réalisées avant l'apparition des ruptures physiques sur les conducteurs.

On propose de plus un procédé de surveillance tel que précédemment décrit, dans lequel la liste de configurations de connexion comprend des deuxièmes configurations de connexion correspondant chacune, pour l'une des phases, à une inversion du neutre et de ladite phase.

On propose de plus un procédé de surveillance tel que précédemment décrit, dans lequel la liste de configurations de connexion comprend des troisièmes configurations de connexion correspondant chacune à l'une des phases qui est déconnectée et qui se retrouve mise au potentiel d'une autre phase.

On propose de plus un procédé de surveillance tel que précédemment décrit, dans lequel la mise en oeuvre de l'algorithme exploratoire comprend les étapes de :

- tester une configuration de connexion, en vérifiant si des critères prédéterminés associés à ladite configuration de connexion sont remplis, les critères prédéterminés étant définis à partir des paramètres électriques ;
- si les critères prédéterminés sont remplis, en déduire que ladite configuration de connexion est celle qui correspond aux valeurs courantes des paramètres électriques ;
- sinon, réitérer l'étape de test avec une autre configuration de connexion.

On propose de plus un procédé de surveillance tel que précédemment décrit, dans lequel les paramètres électriques comprennent :

- des tensions simples mesurées, chaque tension simple mesurée étant représentative d'une amplitude d'une tension simple entre l'une des phases et le neutre, et/ou
- des tensions composées mesurées, chaque tension composée mesurée étant représentative d'une amplitude d'une tension composée entre deux phases distinctes, et/ou
- des angles mesurés, chaque angle mesuré étant égal à un angle entre une représentation vectorielle d'une tension simple entre une phase et le neutre, et entre une représentation vectorielle d'une tension simple entre une autre phase et le neutre.

On propose de plus un procédé de surveillance tel que précédemment décrit, dans lequel les angles mesurés sont obtenus en mettant en oeuvre une méthode de détection de passage à zéro sur les tensions mesurées entre les phases et le neutre.

On propose de plus un procédé de surveillance tel que précédemment décrit, dans lequel l'algorithme exploratoire mis en oeuvre est un premier algorithme exploratoire qui utilise uniquement, comme paramètres électriques, les tensions simples mesurées et les tensions composées mesurées.

On propose de plus un procédé de surveillance tel que précédemment décrit, dans lequel le premier algorithme exploratoire comprend l'étape de tenter de détecter une ou des tensions composées mesurées qui sont anormales, le premier algorithme exploratoire consistant alors à tester des ensembles de configurations de connexion, qui sont définis en fonction du nombre de tensions composées mesurées anormales.

On propose de plus un procédé de surveillance tel que précédemment décrit, dans lequel la tension composée mesurée $U'_i$ est considérée comme anormale si :

$U'_i < \text{Uprev}_i - \alpha$ ou si $U'_i > \text{Uprev}_i + \alpha$,

où :

$\alpha$ est une marge d'incertitude,
et où :

$$\text{Uprev}_i = V_n.\text{SQRT}(ai^2 + aj^2 + ai.aj),$$

où $ai = V_i/V_n$, $aj = V_j/V_n$, $V_i$ est la tension simple mesurée pour la phase Pi, $V_j$ est la tension simple mesurée pour la phase Pj, et $V_n$ est une tension simple nominale.

On propose de plus un procédé de surveillance tel que précédemment décrit, dans lequel les critères prédéterminés comprennent des comparaisons réalisées chacune entre :

- une tension résultante, obtenue en sommant :

  ∘ deux tensions simples mesurées différentes, ou
  ∘ une tension simple mesurée et une tension composée mesurée,

- et une tension simple mesurée ou une tension composée mesurée.

On propose de plus un procédé de surveillance tel que précédemment décrit, dans lequel l'algorithme exploratoire mis en oeuvre est un deuxième algorithme exploratoire qui utilise uniquement, comme paramètres électriques, les tensions simples mesurées et les angles mesurés.

On propose de plus un procédé de surveillance tel que précédemment décrit, dans lequel les critères prédéterminés, associés aux configurations de connexion suivantes, comprennent uniquement des comparaisons entre les angles mesurés et des seuils angulaires :

- le neutre et toutes les phases sont normalement connectés ;
- le neutre est inversé avec l'une des phases ;
- le neutre est déconnecté et toutes les phases sont connectées.

On propose de plus un procédé de surveillance tel que précédemment décrit, dans lequel le deuxième algorithme exploratoire teste si un câblage des phases au compteur est réalisé selon un ordre direct ou indirect.

On propose de plus un équipement électrique comprenant des capteurs de tension et une unité de traitement dans laquelle est mis en oeuvre le procédé de surveillance tel que précédemment décrit.

On propose de plus un équipement électrique tel que précédemment décrit, l'équipement électrique étant un compteur.

On propose de plus un programme d'ordinateur comprenant des instructions qui conduisent l'unité de traitement de l'équipement électrique tel que précédemment décrit à exécuter les étapes du procédé de surveillance tel que précédemment décrit.

On propose de plus un support d'enregistrement lisible par ordinateur, sur lequel est enregistré le programme d'ordinateur tel que précédemment décrit.

L'invention sera mieux comprise à la lumière de la description qui suit de modes de mise en oeuvre particuliers non limitatifs de l'invention.

BREVE DESCRIPTION DES DESSINS

Il sera fait référence aux dessins annexés parmi lesquels :

[Fig. 1] la figure 1 représente deux compteurs électriques connectés à un réseau dont le neutre est coupé ;
[Fig. 2] la figure 2 représente un compteur électrique dans lequel est mise en oeuvre l'invention ;
[Fig. 3] la figure 3 représente un diagramme de Fresnel dans le cas nominal, sans perte de neutre ;
[Fig. 4] la figure 4 comprend un premier schéma représentant une coupure de neutre sur le réseau, et un deuxième schéma représentant une coupure de la phase P1 ;
[Fig. 5] la figure 5 illustre l'effet, en aval du point de rupture, de la perte du neutre sur le diagramme de Fresnel ;
[Fig. 6] la figure 6 représente le résultat, sur les tensions représentées dans des diagrammes de Fresnel, de différentes configurations de connexion ;
[Fig. 7] la figure 7 représente des étapes du procédé de surveillance selon l'invention.

DESCRIPTION DETAILLEE DE L'INVENTION

En référence à la figure 2, un compteur électrique polyphasé 5 (ici triphasé) est connecté à un réseau électrique polyphasé 6 (ici triphasé) comprenant trois phases P1, P2, P3 et un neutre N. Le compteur 5 est destiné à mesurer l'énergie électrique distribuée par le réseau électrique 6 à l'installation 7 d'un utilisateur.

Le compteur électrique 5 comprend, pour chaque phase Pi (i allant de 1 à 3), une borne 8 relié à ladite phase Pi et un conducteur de phase 9 relié à ladite borne 8. Le compteur électrique 5 comprend aussi une borne 10 reliée au neutre N et un conducteur de neutre 11 relié à la borne 10.

Le compteur 5 comprend de plus des capteurs de tension qui sont reliés au réseau électrique 6 via les conducteurs de phase 9 et de neutre 11, et via les bornes 8 et 10. Les capteurs de tension permettent de mesurer :

- la tension simple $V'1$ entre la phase P1 et le neutre N, qui est (normalement) l'image, au niveau du compteur 5, de la tension simple V1 du réseau 6 ;
- la tension simple $V'2$ entre la phase P2 et le neutre N, qui est (normalement) l'image, au niveau du compteur 5, de la tension simple V2 du réseau 6 ;
- la tension simple $V'3$ entre la phase P3 et le neutre N, qui est (normalement) l'image, au niveau du compteur 5, de la tension simple V3 du réseau 6.

Les capteurs de tension comprennent un premier pont résistif, un deuxième pont résistif, un troisième pont résistif et un convertisseur analogique-numérique 14 (CAN).

Le premier pont résistif comprend deux résistances $R_{1A}$ et $R_{1B}$ montées entre le conducteur de phase 9 relié à la phase P1, et le conducteur de neutre 11. Le deuxième pont résistif comprend deux résistances $R_{2A}$ et $R_{2B}$ montées entre le conducteur de phase 9 relié à la phase P2, et le conducteur de neutre 11. Le troisième pont résistif comprend deux résistances $R_{3A}$ et $R_{3B}$ montées entre le conducteur de phase 9 relié à la phase P3, et le conducteur de neutre 11.

Le CAN 14 comprend une première entrée reliée à un point situé entre les deux résistances $R_{1A}$ et $R_{1B}$, une deuxième entrée reliée à un point situé entre les deux résistances $R_{2A}$ et $R_{2B}$, et une troisième entrée reliée à un point situé entre les deux résistances $R_{3A}$ et $R_{3B}$.

Les ponts résistifs permettent de réduire l'amplitude des tensions mesurées pour que celles-ci soient compatibles avec la plage de mesure du CAN 14. Le CAN 14 numérise les tensions mesurées.

Les caractéristiques du CAN 14 (nombres de bits, fréquence d'échantillonnage) sont compatibles avec le besoin pour réaliser des mesures de tensions exploitables. Typiquement, le CAN 14 utilisé est un CAN de 12 bits ou plus, avec une fréquence d'échantillonnage de 1ksps.

Le compteur électrique 5 comprend de plus une unité de traitement 15.

L'unité de traitement 15 comprend un ou plusieurs composants de traitement 16, et par exemple un processeur ou un microprocesseur quelconque(s), généraliste(s) ou spécialisé(s) (par exemple un DSP, pour *Digital Signal Processor),* un microcontrôleur, ou bien un circuit logique programmable tel qu'un FPGA (pour *Field Programmable Gate Arrays*) ou un ASIC (pour *Application Spécifie Integrated Circuit*).

L'unité de traitement 15 comprend aussi des mémoires 17. Au moins l'une de ces mémoires 17 forme un support d'enregistrement lisible par ordinateur, sur lequel est enregistré au moins un programme d'ordinateur comprenant des instructions qui conduisent l'unité de traitement 15 à exécuter au moins certaines des étapes du procédé de surveillance selon l'invention. L'une de ces mémoires 17 peut être intégrée dans l'un des composants de traitement 16.

Ici, le CAN 14 est intégré dans l'unité de traitement 15, et éventuellement dans l'un des composants de traitement 16.

L'unité de traitement 15 acquiert donc les mesures des tensions simples *V'*1, *V'*2, *V'*3 et produit à partir de ces mesures de tensions des mesures de :

- la tension composée *U'*1 entre la phase P1 et la phase P2, qui est (normalement) l'image, au niveau du compteur 5, de la tension *U*1 du réseau 6 ;
- la tension composée *U'*2 entre la phase P2 et la phase P3, qui est (normalement) l'image, au niveau du compteur 5, de la tension *U*2 du réseau 6 ;
- la tension composée *U'*3 entre la phase P3 et la phase P1, qui est (normalement) l'image, au niveau du compteur 5, de la tension *U*3 du réseau 6.

Chacune de ces tensions composées, à chaque instant d'échantillonnage, est obtenue par soustraction des deux tensions simples des phases concernées.

Les tensions considérées par la suite sont :

- des tensions simples mesurées, chaque tension simple mesurées étant représentative d'une amplitude d'une tension simple entre l'une des phases et le neutre ;
- des tensions composées mesurées, chaque tension composée mesurée étant représentative d'une amplitude d'une tension composée entre deux phases distinctes.

Ici, les tensions simples mesurées et les tensions composées mesurées sont des tensions efficaces - mais les tensions représentatives des amplitudes pourraient être différentes, par exemple des valeurs d'amplitude maximale.

Les tensions considérées pour la suite sont donc des tensions efficaces calculées (et éventuellement corrigées par des paramètres de calibration) sur la base des échantillons des mesures de tensions simples (par exemple chaque seconde sur la base des échantillons de la seconde précédente, ou sur une seconde glissante, ou sur une autre profondeur temporelle jugée judicieuse).

L'unité de traitement 15 estime donc les tensions simples mesurées $V'_1$ (qui est la tension efficace de la tension $\overrightarrow{V'_1}$), $V'_2$ et $V'_3$, ainsi que les tensions composées mesurées $U'_1$ (qui est la tension efficace de la tension $\overrightarrow{U'_1}$), $U'_2$ et $U'_3$.

L'unité de traitement estime aussi des angles mesurés $Phi_1$, $Phi_2$ et $Phi_3$. Chaque angle mesuré est égal à un angle entre une représentation vectorielle d'une tension simple entre une phase et le neutre, et entre une représentation vectorielle d'une tension simple entre une autre phase et le neutre.

Ainsi, $Phi_1$ est l'angle entre $\overrightarrow{V'_1}$ et $\overrightarrow{V'_2}$, $Phi_2$ est l'angle entre $\overrightarrow{V'_2}$ et $\overrightarrow{V'_3}$, $Phi_3$ est l'angle entre $\overrightarrow{V'_3}$ et $\overrightarrow{V'_1}$.

Les angles mesurés sont estimés en mettant en oeuvre une méthode de détection de passage à zéro (*Zero-*

*Crossing*) et un filtrage adéquat sur les mesures de tensions - et en particulier sur les tensions simples mesurées.

L'invention vise à détecter une perte de neutre et/ou de phase(s), en se basant uniquement sur l'analyse des seules mesures de tensions réalisées par le compteur électrique 5, et sans utiliser de mesures de référence préalable à l'instant d'apparition de rupture d'un ou plusieurs conducteur(s) provenant du réseau.

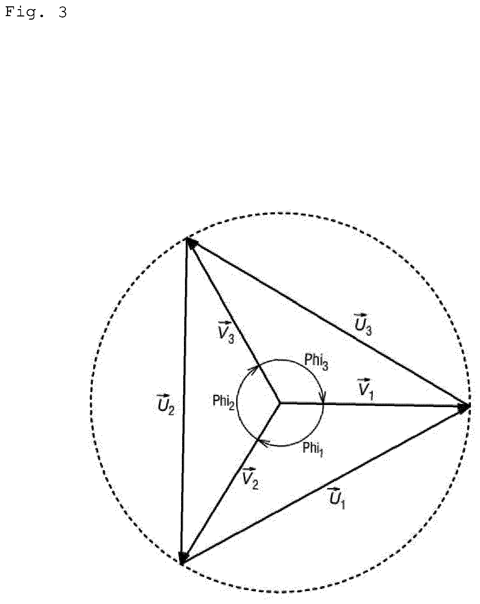

On voit sur la figure 3 le diagramme de Fresnel dans le cas nominal, lorsque le neutre est présent et avec les tensions simples $\vec{V_1}$, $\vec{V_2}$, $\vec{V_3}$ équilibrées. On voit aussi les vecteurs $\vec{U_1}$, $\vec{U_2}$, $\vec{U_3}$ et les angles Phi$_1$, Phi$_2$ et Phi$_3$.

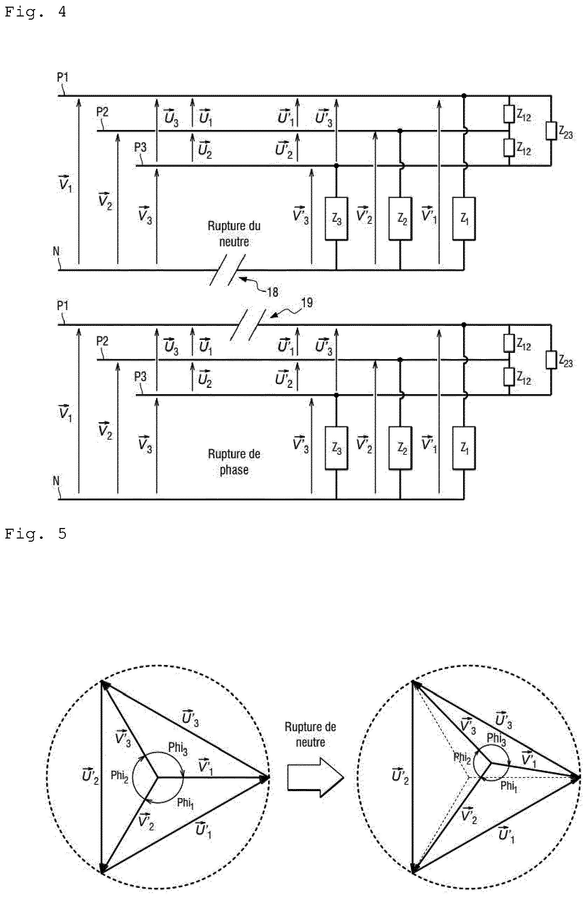

Le schéma du haut de la figure 4 illustre et modélise la situation obtenue à la suite d'une perte de neutre (coupure du neutre). Le point de rupture 18 du neutre N est supposé localisé en amont du compteur 5. La ligne de neutre située en aval du point de rupture 18 devient flottante, et s'établit au gré des charges situées en aval du point de rupture qui lui sont liées ($Z_1$, $Z_2$, $Z_3$, $Z_{12}$, $Z_{12}$, $Z_{23}$). Ici, par « en amont », on entend du côté du réseau 6 et par « en aval », on entend du côté de l'installation 7.

Le schéma du bas de la figure 4 illustre et modélise la situation obtenue à la suite d'une perte de la phase P1 (coupure de la phase). Le point de rupture 19 de la phase P1 est supposé localisé en amont du compteur 5. La ligne de phase située en aval du point de rupture 19 devient flottante, et s'établit au gré des charges situées en aval du point de rupture qui lui sont liées. On constate dans ce cas particulier que les tensions mesurées V'$_2$, V'$_3$ et U'$_2$ correspondent aux tensions réelles du réseau ($V_2$, $V_3$ et $U_2$). En revanche, les tensions mesurées V'$_1$, U'$_1$ et U'$_3$ ne sont plus celles du réseau (V1, U1 et U3) sauf cas particulier de charges avales parfaitement équilibrées.

Bien que cette situation ne soit pas illustrée sur la figure 4, on peut également considérer deux points de rupture (sur une phase et le neutre, ou bien sur deux phases). De la même manière, la tension sur chacune des deux lignes devenues flottantes s'établit au gré des charges situées en aval des points de rupture qui leur sont respectivement liés.

En référence à la figure 5, à la suite de la perte du neutre N, par exemple, les tensions s'équilibrent naturellement en fonction des charges avales : sur le diagramme de Fresnel, la position du neutre devenu flottant en aval du point de rupture est localisée « quelque part » dans le triangle formé par les trois phases, au gré des valeurs de charges avales.

On constate ainsi sur la figure 5 que, dans le cas de la perte du neutre, les tensions composées mesurées correspondent aux tensions composées réelles du réseau (U'$_x$ = U$_x$). En revanche, les tensions simples mesurées ne sont plus celles du réseau (V'$_x$ ≠ V$_x$), sauf cas particulier de charges avales parfaitement équilibrées. On note que la figure 5 illustre cette situation avec un hypothétique déséquilibre des charges avales.

Le procédé de surveillance selon l'invention consiste à détecter une coupure du neutre et/ou d'une ou de plusieurs phases, en se basant uniquement sur les mesures de tension.

L'invention comporte tout d'abord une étape préliminaire, qui consiste à lister et étudier de manière systématique et exhaustive les différents cas de figure possibles, et à définir pour chacune des configurations de connexion considérées les valeurs attendues de paramètres électriques obtenus à partir des mesures de tensions.

On crée donc une table de référence 20 (voir figure 2), qui comprend une liste de configurations de connexion associées chacune à une combinaison distincte de valeurs de référence desdits paramètres électriques.

La liste de configurations de connexion comprend tout d'abord des premières configurations de connexion correspondant chacune à une combinaison distincte d'états de connexion (normale) ou de déconnexion (coupure) pour chaque phase Pi et pour le neutre N.

Par exemple, une première configuration de connexion correspond à la combinaison :

N : OFF - P1 : ON - P2 : ON - P3 : ON,
où « OFF » signifie que la ligne en question (phase ou neutre) est déconnectée et donc présente une coupure, et où « ON » signifie au contraire que la connexion est normale.
D'autres premières combinaisons de connexion sont par exemple :

N : ON - P1 : OFF - P2 : ON - P3 : ON,
N : ON - P1 : OFF - P2 : OFF - P3 : ON,
etc.

La liste de configurations de connexion comprend aussi des deuxièmes configurations de connexion correspondant chacune, pour l'une des phases, à une inversion du neutre et de ladite phase au niveau des bornes 8 et 10 du compteur 5. L'inversion résulte par exemple d'une mauvaise manipulation au moment de l'installation du compteur 5.

Par exemple, une deuxième configuration de connexion correspond à la combinaison :
N : ON (invert) - P1 : ON (invert) - P2 : ON - P3 : ON.

Dans cette deuxième configuration de connexion, le neutre et la phase P1 ne sont pas coupés mais sont inversés.

La liste de configurations de connexion comprend aussi des troisièmes configurations de connexion correspondant chacune à l'une des phases qui est déconnectée et qui, du fait des conditions de charges avales, se retrouve mise au potentiel d'une autre phase.

Par exemple, une troisième configuration de connexion correspond à la combinaison :
N : ON - P1 : OFF (ON) - P2 : ON - P3 : ON.

Dans cette troisième configuration de connexion, la phase P1 est coupée mais est mise au potentiel de l'une des phases P2 ou P3.

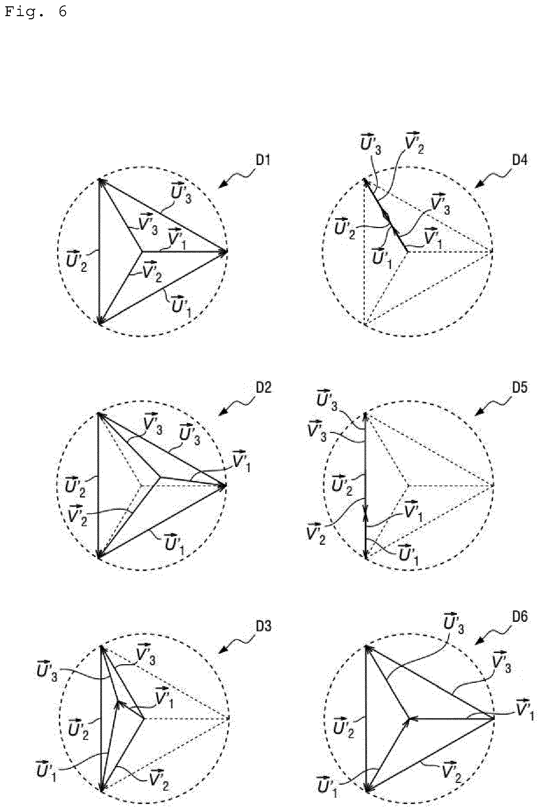

On représente sur la figure 6 un certain nombre de configurations de connexion :

- sur le diagramme D1, toutes les lignes N, P1, P2, P3 sont connectées (conditions nominales), ou bien le neutre N est déconnecté mais les charges sont équilibrées ;
- sur le diagramme D2, le neutre N est déconnecté et les charges sont déséquilibrées ;
- sur le diagramme D3, la phase P1 est déconnectée ;
- sur le diagramme D4, la phase P1 et la phase P2 sont déconnectées ;
- sur le diagramme D5, le neutre N et la phase P1 sont déconnectés ;
- sur le diagramme D6, le neutre N et la phase P1 sont inversés.

Dans la table de référence 20 qui a été précédemment évoquée, les paramètres électriques utilisés comprennent :

- les tensions simples mesurées, chaque tension simple mesurées étant représentative (comme on l'a vu) d'une amplitude d'une tension simple entre l'une des phases et le neutre, et/ou
- des tensions composées mesurées, chaque tension composée mesurée étant représentative (comme on l'a vu) d'une amplitude d'une tension composée entre deux phases distinctes, et/ou
- des angles mesurés, chaque angle mesuré étant égal (comme on l'a vu) à un angle entre une représentation vectorielle d'une tension simple entre une phase et le neutre, et entre une représentation vectorielle d'une tension simple entre une autre phase et le neutre.

La table de référence 20 a donc été créée en bureau d'étude, en laboratoire ou en usine, et a été téléchargée dans l'une des mémoires 17 de l'unité de traitement 15. Alternativement, la table de référence 20 peut être stockée à distance (dans un concentrateur de données, dans un serveur du Système d'Information, sur le *cloud,* etc.), et l'unité de traitement 15 du compteur 5 peut y accéder via des moyens de communication adaptés. La table de référence 20 peut être mise à jour alors que le compteur 5 est en opération.

Les inventeurs ont donc analysé la table de référence 20, et en ont déduit le cheminement exploratoire et des critères discriminants pour statuer, en opération, de manière fiable, sur la configuration de connexion présente - en, en particulier, sur la présence ou l'absence du neutre N et des phases Pi.

Un exemple de table de référence est fourni en Annexe 1 de la présente description.

La table de référence 20 répertorie de manière quasi exhaustive les différents cas de figure pratiques, et indique les caractéristiques de chacun de ces cas (position de chaque ligne dans le diagramme de Fresnel de référence, valeurs des tensions simples, des tensions composées, des angles entre phases). La table annexée se limite toutefois, par souci de simplicité et de lisibilité à des tensions simples égales et nominales ($V_1 = V_2 = V_3 = V_n$), et dans le cas d'un câblage des phases selon un ordre direct.

Dans la table annexée figurent en gras les cas de figure génériques pour un cas de connexion donné, et en non gras les cas de figure particuliers (typiquement lorsque les conditions de charges avales sont telles qu'une ligne déconnectée se retrouve mise au même potentiel d'une autre ligne).

Une analyse attentive et une étude systématique a montré que sur la seule base des tensions simples mesurées, et/ou des tensions composées mesurées et/ou des différences d'angles de phase, il est possible de discriminer chacun de ces cas, et donc de déduire de manière certaine dans quel cas de figure on se trouve et finalement quelles lignes sont présentes ou perdues (neutre et/ou phase(s)).

Une algorithmie adéquate qui explore itérativement les différentes configurations possibles et vérifie à chaque étape si les critères (tensions simples et tensions composées et/ou tensions simples et angles) correspondant à la configuration particulière considérée sont rencontrés est alors utilisée.

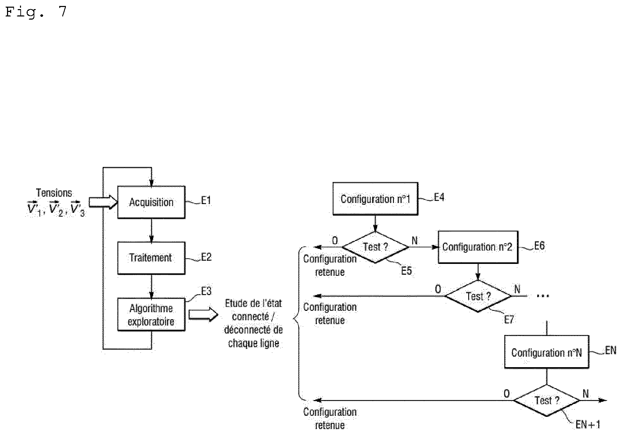

En référence à la figure 7, le procédé de surveillance selon l'invention consiste donc pour l'unité de traitement 15 à acquérir des mesures de tensions réalisées par les capteurs de tension du compteur 5 : étape E1.

Les mesures de tensions sont alors traitées pour produire les valeurs courantes des paramètres électriques : calcul des tensions simples mesurées, des tensions composées mesurées, des différences d'angles de phase, etc. : étape E2.

L'unité de traitement 15 accède alors à la table de référence 20 et met en oeuvre un algorithme exploratoire, destiné à parcourir la table de référence pour identifier la configuration de connexion associée aux valeurs courantes des paramètres électriques : étape E3.

L'algorithme exploratoire permet de classer l'état actuel sur la base des valeurs courantes des paramètres électriques, parmi les cas d'étude multiples et exhaustifs. L'algorithme exploratoire permet une exploration systématique et exhaustive de la table de référence et donc de tous les cas d'étude attendus selon les différents cas de configuration de connexion possibles.

Les informations d'entrée de l'algorithme exploratoire sont donc les valeurs en cours des paramètres électriques. En sortie dudit algorithme exploratoire, il est déclaré quelle(s) ligne(s) (neutre et/ou phase(s)) sont connectée(s) ou déconnectée(s).

Ce mécanisme de détection de perte de neutre et/ou de phase(s) est réalisé en continu (par exemple en boucle, toutes les secondes, lorsque des nouvelles valeurs de mesures de tensions sont disponibles).

L'algorithme exploratoire comprend ensuite les étapes de :

- tester une configuration de connexion, en vérifiant si des critères prédéterminés associés à ladite configuration de connexion sont remplis, les critères prédéterminés étant définis à partir des paramètres électriques ;
- si les critères prédéterminés sont remplis, en déduire que ladite configuration de connexion est celle qui correspond aux valeurs courantes des paramètres électriques ;
- sinon, réitérer l'étape de test avec une autre configuration de connexion.

L'algorithme exploratoire acquiert des premiers critères prédéterminés, associés à une configuration de connexion numéro 1, correspondant à une première hypothèse d'état des lignes (phases et neutre) : étape E4.

L'algorithme exploratoire teste si ces premiers critères prédéterminés sont remplis : étape E5. Si c'est le cas, l'algorithme exploratoire en déduit que la configuration de connexion effective, en cours, correspond à la configuration de connexion numéro 1.

Sinon, l'algorithme exploratoire acquiert des deuxièmes critères prédéterminés, associés à une configuration de connexion numéro 2, correspondant à une deuxième hypothèse d'état des lignes (phases et neutre) : étape E6.

L'algorithme exploratoire teste si ces deuxièmes critères prédéterminés sont remplis : étape E7. Si c'est le cas, l'algorithme exploratoire en déduit que la configuration de connexion effective, en cours, correspond à la configuration de connexion numéro 2.

Ces étapes sont réitérées un certain nombre de fois. A la Nième itération, l'algorithme exploratoire acquiert des Nièmes critères prédéterminés (étape EN) et teste une configuration de connexion numéro N, correspondant à une Nième hypothèse d'état des lignes : étape EN+1.

Si les Nièmes critères prédéterminés sont remplis, l'algorithme exploratoire en déduit que la configuration de connexion effective, en cours, correspond à la configuration de connexion numéro N. Sinon, l'algorithme exploratoire en déduit que la configuration de connexion correspond à un cas de connexion inconnu.

Le nombre N est le nombre de configurations de connexion différentes listées dans la table de référence 20.

On s'intéresse maintenant plus particulièrement à l'algorithme exploratoire.

On décrit tout d'abord un premier algorithme exploratoire. Le premier algorithme exploratoire utilise uniquement, comme paramètres électriques, les tensions simples mesurées et les tensions composées mesurées.

Le premier algorithme exploratoire, écrit en pseudo-langage et donc aisément transcriptible à tous les principaux langages informatiques, est fourni dans l'Annexe 2.

Le premier algorithme exploratoire comprend tout d'abord une partie préliminaire définissant une pluralité de paramètres et, en particulier, un seuil de tension très bas Voff. Ce seuil, auquel sont comparées les tensions simples mesurées, correspond à une tension si basse que ladite tension peut être assimilée à une absence de phase.

Puis, le premier algorithme exploratoire comprend une instruction de bouclage, chaque seconde. En effet, comme on l'a vu, les étapes du procédé de surveillance sont répétées régulièrement : à intervalles réguliers (1s ici), l'unité de traitement 15 acquiert de nouvelles mesures de tensions et produit de nouvelles valeurs courantes des paramètres électriques. Le premier algorithme exploratoire est donc répété chaque seconde pour identifier la nouvelle configuration de connexion associée aux nouvelles valeurs courantes des paramètres électriques.

Le premier algorithme exploratoire calcule alors les tensions composées attendues à partir des tensions simples mesurées, dans le cas où aucune ligne n'est coupée.

Le premier algorithme exploratoire tente alors de détecter une ou des tensions composées mesurées qui sont anormales.

Pour les phases Pi et Pj, la tension composée mesurée $U'_i$ est considérée comme anormale si :

$U'_i < Uprev_i - \alpha$ ou si $U'_i > Uprev_i + \alpha$,
où :

$\alpha$ est une marge d'incertitude,
et où :

$$Uprev_i = V_n.SQRT(ai^2+aj^2+ai.aj),$$

où $ai = V_i/V_n$, $aj = V_j/V_n$, $V_i$ est la tension simple mesurée pour la phase Pi, $V_j$ est la tension simple mesurée pour la phase Pj, et $V_n$ est une tension simple nominale.

La formule ci-dessus correspond à :

$$U_n = SQRT(3).V_n$$

que l'on obtient dans le cas nominal de tensions équilibrées et à la valeur nominale. On note que cette relation est exacte si et seulement si la relation d'angle entre les phases Pi et Pj est de 120°. Un non-respect de la mesure de $U'_i$ avec le calcul donné ci-dessus et obtenu avec les mesures $V'_i$ et $V'_j$ suffit donc à prouver que la relation d'angle entre les phases i et j n'est pas de 120°.

Le premier algorithme exploratoire consiste alors à tester des ensembles de configurations de connexion, en vérifiant si des critères prédéterminés associés aux configurations de connexion sont remplis.

Ici, les critères prédéterminés comprennent des comparaisons réalisées chacune entre :

- une tension résultante, obtenue en sommant :

  ◦ deux tensions simples mesurées différentes, ou
  ◦ une tension simple mesurée et une tension composée mesurée,

- et une tension simple mesurée ou une tension composée mesurée.

Les ensembles de configuration sont définis en fonction du nombre de tensions composées mesurées anormales.

Ainsi, si le nombre de tensions composées mesurées anormales est égal à zéro, le premier algorithme exploratoire considère par défaut que la configuration de connexion effective, en cours au temps T, est une configuration de connexion nominale, dans laquelle le neutre et les phases sont connectés normalement, puis teste des configurations de connexion dans lesquelles au moins une phase est déconnectée.

Le premier algorithme exploratoire considère donc tout d'abord par défaut que le neutre et les trois phases sont connectés normalement.

Le premier algorithme exploratoire tente alors de détecter une ou des phases déconnectées, en comparant, pour chaque phase Pi, la tension simple mesurée $V'_i$ avec le seuil Voff. Si pour une phase Pi la tension simple mesurée est strictement inférieure à Voff, ladite phase Pi est considérée comme déconnectée.

Si le nombre de tensions composées mesurées anormales est égal à un, le premier algorithme exploratoire considère par défaut que la configuration de connexion effective est une configuration de connexion nominale, puis teste des configurations de connexion dans lesquelles une seule phase est déconnectée, et des configurations de connexion dans lesquelles une phase est déconnectée et se retrouve mise au potentiel d'une autre phase.

Le premier algorithme exploratoire considère donc par défaut que le neutre et les trois phases sont normalement connectés.

Puis, pour chaque phase Pi, l'algorithme vérifie si

$V'i + U'i = V'j$, ou si $V'i + u'k = V'k$ (avec j = i+1 et k = i+2).

Si c'est le cas, l'algorithme en déduit que la phase Pi est déconnectée.

Si l'algorithme a détecté que la phase Pi est déconnectée, l'algorithme vérifie alors si :

$$V'i = V'j \text{ ou si } V'i = V'k.$$

Si c'est le cas, il en déduit que la phase Pi est connectée sur une autre phase.

Si le nombre de tensions composées mesurées anormales est égal à deux, le premier algorithme exploratoire considère par défaut que la configuration de connexion effective est une configuration de connexion nominale, puis teste des configurations de connexion dans lesquelles une seule phase est déconnectée (et ramenée entre les deux autres phases et le neutre).

Le premier algorithme exploratoire considère donc par défaut que le neutre et les trois phases sont normalement connectés.

Puis, pour chaque phase Pi, l'algorithme vérifie si

$$V'i < V'j \text{ et } U'i < V'j$$

ou si

$$V'i < V'k \text{ et } U'k < V'k.$$

Si c'est le cas, l'algorithme en déduit que la phase Pi est déconnectée.

Si le nombre de tensions composées mesurées anormales est égal à trois, le premier algorithme exploratoire considère par défaut que la configuration de connexion effective est une configuration de connexion dans laquelle le neutre uniquement est coupé (et dans laquelle il y a manifestement un déséquilibre significatif des charges avales), puis teste des configurations de connexion dans lesquelles une phase et le neutre sont coupés (et ramenés entre les deux autres phases), puis une configuration de connexion dans laquelle une phase est connectée sur une autre phase, puis des configurations de connexion dans lesquelles deux phases sont coupées (ramenées entre le neutre et la phase restante), puis une configuration de connexion dans laquelle trois phases sont connectées entre elles, puis des configurations de connexion dans lesquelles une phase est inversée avec le neutre.

Le premier algorithme exploratoire considère tout d'abord par défaut que le neutre est déconnecté et que les trois phases sont bien connectées.

Puis, pour chaque phase Pi, l'algorithme vérifie si :

$$V'j + V'k = U'j \text{ et } U'i + U'k = U'j$$

Si c'est le cas, l'algorithme en déduit que la phase Pi est déconnectée.

Si l'algorithme a détecté que la phase Pi est déconnectée, il vérifie alors si :

$$U'i = U'j \text{ ou si } U'k = U'j.$$

Si c'est le cas, il en déduit que la phase Pi est connectée sur une autre phase.

Puis, l'algorithme tente de détecter la perte de deux phases uniquement (ramenées entre le neutre et la phase restante).

Pour chaque phase Pi, l'algorithme vérifie si :

$$V'i + U'k = V'k \text{ et } V'j + U'j = V'k$$

Si c'est le cas, l'algorithme en déduit que la phase Pi et la phase Pj sont déconnectées.

Si l'algorithme a détecté que la phase Pi et la phase Pj sont déconnectées, l'algorithme vérifie alors si :

$$V'i = V'j \text{ et si } V'i = V'k.$$

Si c'est le cas, il en déduit que les trois phases sont connectées entre elles.

Puis, l'algorithme tente de détecter une inversion entre le neutre et une phase sur le câblage du compteur 5.

Pour chaque phase Pi, l'algorithme calcule les tensions composées attendues Uprev_inv[i], Uprev_inv[j], Uprev_inv[k] connaissant les tensions simples mesurées et en supposant une inversion entre le neutre et la phase Pi.

Si on a :

Uprev_inv[i] = V'j et Uprev_inv[j] = U'j et Uprev_inv[k] = V'k, l'algorithme en déduit que le neutre et la phase Pi sont inversés.

Puis, pour chaque phase Pi, l'algorithme compare la tension simple V'i avec des seuils prédéterminés pour donner un statut concernant les niveaux de tension provenant du réseau : surtension, sous-tension, sous-tension importante, surtension dangereuse, etc.

L'algorithme donne aussi un statut sur la dangerosité du niveau de tension côté aval, et éventuellement, pilote l'ouverture des organes de coupure (*breakers*) pour protéger les équipements branchés en aval du compteur 5 (équipements de l'installation 7).

On note que toutes ces comparaisons peuvent être réalisées en ajoutant des marges pour tenir compte des incertitudes ; par exemple, comme cela est bien visible dans le premier algorithme exploratoire fourni en Annexe 2, plutôt que de vérifier si :

$$V'i + U'i = V'j \text{ ou } V'i + U'k = V'k,$$

on vérifiera si

$$V'i + U'i = V'j +/-(2.Y) \text{ ou } V'i + U'k = V'k +/-(2.Y),$$

Y étant une marge permettant de tenir compte de l'incertitude sur les mesures de tensions.

Le premier algorithme exploratoire (tout comme le deuxième qui sera décrit ci-après) prévoit donc des marges nécessaires pour tenir compte des incertitudes de mesures, et des tolérances initiales du réseau électrique.

On décrit maintenant un deuxième algorithme exploratoire.

Le deuxième algorithme exploratoire utilise uniquement, comme paramètres électriques, les tensions simples mesurées et les angles mesurés.

Le deuxième algorithme exploratoire, écrit en pseudo-langage, est fourni dans l'Annexe 3.

Le deuxième algorithme exploratoire comprend tout d'abord une partie préliminaire définissant une pluralité de paramètres et, en particulier, un seuil angulaire haut et un seuil angulaire bas.

Puis, le deuxième algorithme exploratoire comprend une instruction de bouclage, chaque seconde.

Le deuxième algorithme exploratoire compare alors chaque tension simple mesurée avec le seuil Voff et, si toutes les tensions simples mesurées sont strictement inférieures audit seuil Voff, l'algorithme est inhibé.

Pour chaque phase Pi, si la tension simple mesurée sur la phase Pi est strictement inférieure au seuil prédéterminé Voff, les angles mesurés impliquant ladite phase ne sont pas considérés comme fiables et sont mis à zéro.

L'algorithme teste tout d'abord une configuration de connexion nominale, dans laquelle le neutre et les phases sont connectés normalement.

L'algorithme compare chaque angle mesuré avec une valeur de référence Aref et, si les angles mesurés sont tous égaux à Aref (éventuellement en tenant compte d'une marge d'incertitude), l'algorithme en déduit que le neutre et les trois phases sont normalement connectés et que le câblage des phases au compteur 5 est réalisé selon un ordre direct.

Si cette condition n'est pas vérifiée, l'algorithme compare alors chaque angle mesuré avec une valeur de référence -Aref et, si les angles mesurés sont tous égaux à -Aref, l'algorithme en déduit que le neutre et les phases sont normalement connectés et que le câblage des phases au compteur est réalisé selon un ordre indirect.

L'algorithme teste alors des configurations de connexion, dans chacune desquelles une phase est inversée avec le neutre.

L'algorithme compare pour cela chaque angle mesuré avec les seuils angulaires haut et bas. Les critères prédéterminés comprennent donc uniquement des comparaisons entre les angles mesurés et des seuils angulaires.

Puis, l'algorithme teste une configuration de connexion, dans laquelle une seule phase est déconnectée, les deux autres phases et le neutre étant normalement connectés. Les critères prédéterminés comprennent des comparaisons entre les angles mesurés et des seuils angulaires, et des comparaisons entre les tensions simples mesurées et des seuils de tension.

Si l'algorithme a détecté une phase déconnectée, il tente alors de détecter si ladite phase est mise au potentiel de l'une des autres phases.

Puis, l'algorithme tente de détecter une configuration de connexion dans laquelle le neutre est déconnecté, les trois autres phases étant toujours connectées.

A nouveau, les critères prédéterminés comprennent uniquement des comparaisons entre les angles mesurés et des seuils angulaires.

L'algorithme teste alors une configuration de connexion dans laquelle deux lignes sont déconnectées, les autres lignes demeurant connectées.

Les critères prédéterminés comprennent des comparaisons entre les angles mesurés et des seuils angulaires, et des comparaisons entre les tensions simples mesurées et des seuils de tension.

L'algorithme tente alors de détecter une configuration de connexion dans laquelle deux phases sont déconnectées, le neutre et l'autre phase demeurant connectés (cas particulier de la configuration ci-dessus).

Si l'algorithme a détecté une phase déconnectée, il tente alors de détecter si ladite phase est mise au potentiel de l'une des autres phases.

L'algorithme tente alors de détecter une configuration de déconnexion dans laquelle le neutre et une phase sont déconnectés, les deux autres phases étant normalement connectées (cas particulier de la configuration ci-dessus).

Si l'algorithme a détecté une phase déconnectée, il tente alors de détecter si ladite phase est mise au potentiel de l'une des autres phases.

Puis, l'algorithme teste une nouvelle fois une configuration de connexion, dans laquelle le neutre et une phase sont déconnectés, les deux autres phases étant normalement connectées.

Enfin, comme le premier algorithme exploratoire, pour chaque phase Pi, le deuxième algorithme exploratoire compare la tension simple V'i avec des seuils prédéterminés pour donner un statut concernant les niveaux de tension provenant du réseau : surtension, sous-tension, sous-tension importante, surtension dangereuse, etc.

L'algorithme donne aussi un statut sur la dangerosité du niveau de tension côté aval, et éventuellement, pilote l'ouverture des organes de coupure (*breakers*) pour protéger les équipements branchés en aval du compteur 5 (équipements de l'installation 7).

Cette invention est donc basée sur des critères aisément mesurables dans le métier (mesures des tensions et leur traitement) et fortement déterministes, et elle ne nécessite aucune mesure de référence remontant à avant la suspicion de perte de neutre. Les mesures de tensions au temps T se suffisent à elles-mêmes pour être capable de dire si oui ou non on a une perte de neutre et/ou de phase(s), puisqu'elles sont suffisantes pour déterminer dans quelle configuration de connexion on se situe, par analyse des conditions caractéristiques correspondantes dans le diagramme de Fresnel.

Dans l'implémentation finale de la solution proposée, et ce quelle que soit la méthode particulière de réalisation, il est avantageux de prendre une marge d'incertitude adéquate, liée notamment à la précision des mesures de tensions et éventuellement d'angles (respectivement typiquement de +/-1V ou +/-1%, et de +/-2°, selon la méthode et les moyens d'acquisition), tel que proposé dans les modes de réalisation particuliers des algorithmes exploratoires fournis.

Eventuellement, pour minimiser les risques de faux positifs, et ce quelle que soit la méthode particulière de réalisation, on pourra s'assurer que les critères prédéterminés de détection sont remplis sur plusieurs itérations consécutives avant de déclarer une perte de neutre et/ou de phase(s) effective(s).

Éventuellement, la détection de perte de neutre et/ou de phase(s) génère une alarme qui est horodatée dans l'une des mémoires 17 de l'unité de traitement 15 du compteur 5 et/ou, pour les compteurs communicants (par exemple au travers d'un canal de transmission reposant sur une technologie CPL ou encore sur une technologie radio cellulaire), un signal d'alarme peut être envoyé à un équipement externe au compteur, et par exemple au Système d'Information distant (éventuellement spontanément, selon le protocole haut niveau utilisé).

Eventuellement, la détection de perte de neutre et/ou de phase(s) génère un affichage particulier et dédié sur l'afficheur local du compteur ou au moyen d'un indicateur lumineux.

Eventuellement, la détection de perte de neutre et/ou de phase(s) génère l'émission d'un signal sonore.

Éventuellement, sur détection de perte de neutre et lorsque le déséquilibre des tensions simples est jugé anormalement important, un signal d'alarme est généré et horodaté dans une mémoire de l'unité de traitement du compteur et/ou, pour les compteurs communicants, envoyé à un équipement externe au compteur, et par exemple au Système d'Information distant.

Éventuellement, sur détection de perte de neutre et lorsque le déséquilibre des tensions simples est jugé trop important et dangereux pour les équipements en aval, pour les compteurs munis d'organes de coupure, ceux-ci sont activés pour passer à l'état ouvert et ainsi protéger les équipements en aval.

Enfin, il est également envisageable d'utiliser différemment l'invention ici proposée pour faire non pas une détection de perte de conducteur (phase(s) et/ou neutre), mais plutôt cette fois une détection automatique du câblage réalisé pour le raccordement au réseau (2 fils, 3 fils, 4 fils, ...) .

Bien entendu, l'invention n'est pas limitée aux modes de réalisation décrits mais englobe toute variante entrant dans le champ de l'invention telle que définie par les revendications.

L'équipement électrique, dans lequel est mis en oeuvre (au moins partiellement) l'invention, n'est pas nécessairement un compteur, mais peut être tout type d'équipement relié à un réseau et pouvant être muni de capteurs de tension (un disjoncteur par exemple).

## Annexes

### Annexe 1

On fournit ici un exemple de table de référence.

La table de référence, qui comprend 32 lignes et 20 colonnes, a été séparée en 4 tableaux pour améliorer la lisibilité de la table.

Le tableau 1 comprend 32 lignes et les 6 colonnes de gauche de la table de référence ; le tableau 2 comprend 32 lignes et 5 colonnes situées à droite des colonnes du tableau 1 ; le tableau 3 comprend 32 lignes et 6 colonnes situées à droite des colonnes du tableau 2 ; le tableau 4 comprend 32 lignes et 3 colonnes situées à droite des colonnes du tableau 3.

Tableau 1 :

| Configurations de connexion | | Presence / Absence de chaque ligne | | | |
| --- | --- | --- | --- | --- | --- |
| | | N | Li | Lj | Lk |
| **Toutes les lignes connectées (Conditions nominales)** | **3P+N** | **ON** | **ON** | **ON** | **ON** |
| **Neutre déconnecté** | **3P** | **OFF** | **ON** | **ON** | **ON** |
| **Neutre déconnecté** | **3P** | **OFF** | **ON** | **ON** | **ON** |
| **Neutre déconnecté** | 3P | OFF | ON | ON | ON |
| **Neutre déconnecté** | 3P | OFF | ON | ON | ON |
| **Neutre déconnecté** | 3P | OFF | ON | ON | ON |
| **Ligne i déconnectée** | **2P+N** | **ON** | **OFF** | **ON** | **ON** |
| **Ligne i déconnectée** | 2P+N | ON | OFF | ON | ON |
| **Ligne i déconnectée** | 2P+N ("false 3P+N") | ON | OFF ("ON") | ON | ON |
| **Ligne i déconnectée** | 2P+N ("false 3P+N") | ON | OFF ("ON") | ON | ON |
| **Ligne i & Ligne j déconnectées** | **1P+N** | **ON** | **OFF** | **OFF** | **ON** |
| **Ligne i & Ligne j déconnectées** | 1P+N | ON | OFF | OFF | ON |
| **Ligne i & Ligne j déconnectées** | 1P+N | ON | OFF | OFF | ON |
| **Ligne i & Ligne j déconnectées** | 1P+N | ON | OFF | OFF | ON |
| **Ligne i & Ligne j déconnectées** | 1P+N | ON | OFF | OFF | ON |
| **Ligne i & Ligne j déconnectées** | 1P+N ("false 2P+N") | ON | OFF ("ON") | OFF | ON |
| **Ligne i & Ligne j déconnectées** | 1P+N ("false 2P+N") | ON | OFF ("ON") | OFF | ON |
| **Ligne i & Ligne j déconnectées** | 1P+N ("false 2P+N") | ON | OFF | OFF ("ON") | ON |
| **Ligne i & Ligne j déconnectées** | 1P+N ("false 2P+N") | ON | OFF | OFF ("ON") | ON |
| **Ligne i & Ligne j déconnectées** | 1P+N ("false 3P+N") | ON | OFF ("ON") | OFF ("ON") | ON |
| **Neutre & Ligne i déconnectés** | **2P** | **OFF** | **OFF** | **ON** | **ON** |
| **Neutre & Ligne i déconnectés** | 2P | OFF | OFF | ON | ON |
| **Neutre & Ligne i déconnectés** | 2P | OFF | OFF | ON | ON |
| **Neutre & Ligne i déconnectés** | 2P | OFF | OFF | ON | ON |
| **Neutre & Ligne i déconnectés** | 2P | OFF | OFF | ON | ON |
| **Neutre & Ligne i déconnectés** | 2P | OFF | OFF | ON | ON |
| **Neutre & Ligne i déconnectés** | 2P | OFF | OFF ("ON") | ON | ON |

(suite)

| Configurations de connexion | | Presence / Absence de chaque ligne | | | |
|---|---|---|---|---|---|
| | | N | Li | Lj | Lk |
| **Neutre & Ligne i déconnectés** | 2P | OFF | OFF ("ON") | ON | ON |
| **Neutre & Ligne i déconnectés** | 2P | OFF | OFF ("ON") | ON | ON |
| **Neutre & Ligne i déconnectés** | 2P | OFF | OFF ("ON") | ON | ON |
| **Neutre & Ligne i déconnectés** | **3P+N N-P invert** | **ON invert** | **ON invert** | **ON** | **ON** |

Tableau 2 :

| Conditions d'impédance entre chaque ligne (du côté aval par rapport au(x) point(s) de déconnexion) | Position de chaque ligne sur le diagramme de Fresnel par rapport aux points de référence de Fresnel ABCD (for i=1 ; j=2 ; k=3) | | | |
|---|---|---|---|---|
| | **N** | **P1** | **P2** | **P3** |
| **Any** | **A** | **B** | **C** | **D** |
| **Equilibré Zi = Zj = Zk** | | | | |
| **Déséquilibré Zi Zj Zk** | **within BCD (except A)** | **B** | **C** | **D** |
| Zi << (Zj & Zk) (e.g. terminal N shunt to terminal i) | B | B | C | D |
| Zj << (Zi & Zk) (e.g. terminal N shunt to terminal j) | C | B | C | D |
| Zk << (Zi & Zj) (e.g. terminal N shunt to terminal k) | D | B | C | D |
| **Any** | **A** | **ACD** | **C** | **D** |
| Zi << (Zij & Zik) | A | A | C | D |
| Zij << (Zi & Zik) (e.g. terminal i shunt to terminal j) | A | C | C | D |
| Zik << (Zi & Zij) (e.g. terminal i shunt to terminal k) | A | D | C | D |
| **Any** | **A** | **[AD]** | **[AD]** | **D** |
| Zij << (Zi & Zik) or Zij << (Zj & Zjk) | A | [AD] | [AD] | D |
| Zi << Zik | A | A | [AD] | D |
| Zj << Zjk | A | [AD] | A | D |
| Zi << Zik and Zj << Zjk | A | A | A | D |
| Zik << Zi (e.g. terminal i shunt to terminal k) | A | D | [AD] | D |
| Zik << Zi and Zj << Zjk | A | D | A | D |
| Zjk << Zj (e.g. terminal j shunt to terminal k) | A | [AD] | D | D |
| Zi << Zik and Zjk << Zj | A | A | D | D |
| Zik << Zi and Zjk << Zj | A | D | D | D |
| **Any** | **[CD]** | **[CD]** | **C** | **D** |
| Zi << (Zij & Zik) or Zi << (Zj & Zk) | [CD] | [CD] | C | D |
| Zj << Zk (e.g. terminal N shunt to terminal j) | C | [CD] | C | D |
| Zj << Zk and Zij << (Zi & Zik) (e.g. terminal N & i shunt to terminal j) | C | C | C | D |

(suite)

| Equilibré Zi = Zj = Zk | | | | |
|---|---|---|---|---|
| **Déséquilibré Zi Zj Zk** | **within BCD (except A)** | **B** | **C** | **D** |
| Zk << Zj (e.g. terminal N shunt to terminal k) | D | [CD] | C | D |
| Zk << Zj and Zik << (Zi & Zij) (e.g. terminal N & i shunt to terminal k) | D | D | C | D |
| Zij << (Zi & Zik) (e.g. terminal i shunt to terminal j) | [CD] | C | C | D |
| Zik << (Zi & Zij) (e.g. terminal i shunt to terminal k) | [CD] | D | C | D |
| Zj << Zk and Zik << (Zi & Zij) (e.g. terminal N shunt to terminal j & terminal i shunt to terminal k) | C | D | C | D |
| Zk << Zj and Zij << (Zi & Zik) (e.g. terminal N shunt to terminal k & terminal i shunt to terminal j) | D | C | C | D |
| **Any** | **B** | **A** | **C** | **D** |

Tableau 3 :

| Angles mesurés entre phases (X : non mesurables, à causes des conditions de basse tension sur la ou les lignes associées | | | Tension mesurées entre ligne et neutre | | |
|---|---|---|---|---|---|
| **α(i,j)** | **α(j,k)** | **α(k,i)** | **V'i** | **V'j** | **V'k** |
| **120°** | **120°** | **120°** | **Vn** | **Vn** | **Vn** |
| **[60°;120°[ ]120°;180°]** | **[60°;120°[ ]120°;180°]** | **[60°;120°[ ]120°;180°]** | **[0;SQRT(3).Vn]** | **[0;SQRT(3).Vn]** | **[0;SQRT(3).Vn]** |
| X | 60° | X | 0 | SQRT(3).Vn | SQRT(3).Vn |
| X | X | 60° | SQRT(3).Vn | 0 | SQRT(3).Vn |
| 60° | X | X | SQRT(3).Vn | SQRT(3).Vn | 0 |
| **[-120°;0°]** | **120°** | **[-120°;0°]** | **[0;Vn]** | **Vn** | **Vn** |
| X | 120° | X | 0 | Vn | Vn |
| 0° | 120° | -120° | Vn | Vn | Vn |
| -120° | 120° | 0° | Vn | Vn | Vn |
| **0°** | **0°** | **0°** | **[0;Vn]** | **[0;Vn]** | **Vn** |
| X | 0° | X | [0;Vn] | [0;Vn] | Vn |
| X | 0° | X | 0 | [0;Vn] | Vn |
| X | X | 0° | [0;Vn] | 0 | Vn |
| X | X | X | 0 | 0 | Vn |
| 0° | 0° | 0° | Vn | [0;Vn] | Vn |
| X | X | 0° | Vn | 0 | Vn |
| 0° | 0° | 0° | [0;Vn] | Vn | Vn |
| X | 0° | X | 0 | Vn | Vn |
| 0° | 0° | 0° | Vn | Vn | Vn |

(suite)

| Angles mesurés entre phases (X : non mesurables, à causes des conditions de basse tension sur la ou les lignes associées) | | | Tension mesurées entre ligne et neutre | | |
|---|---|---|---|---|---|
| 0° ou 180° | 180° | 0° ou 180° | [0;SQRT (3).Vn] | [0;SQRT (3).Vn] | [0;SQRT (3).Vn] |
| X | 180° | X | 0 | [0;SQRT (3).Vn] | [0;SQRT (3).Vn] |
| X | X | 0° | [0;SQRT (3).Vn] | 0 | SQRT (3).Vn |
| X | X | X | 0 | 0 | SQRT (3) .Vn |
| 0° | X | X | [0;SQRT (3).Vn] | SQRT (3).Vn | 0 |
| X | X | X | 0 | SQRT (3).Vn | 0 |
| 0° | 180° | 180° | [0;SQRT (3).Vn] | [0;SQRT (3).Vn] | [0;SQRT (3).Vn] |
| 180° | 180° | 0° | [0;SQRT (3).Vn] | [0;SQRT (3).Vn] | [0;SQRT (3).Vn] |
| X | X | 0° | SQRT (3).Vn | 0 | SQRT (3).Vn |
| 0° | X | X | SQRT (3).Vn | SQRT (3).Vn | 0 |
| **-30°** | **60°** | **-30°** | **Vn** | **SQRT (3).Vn** | **SQRT (3).Vn** |

Tableau 4 :

| Tensions mesurées entre lignes | | |
|---|---|---|
| U'i | U'j | U'k |
| **SQRT(3) .Vn** | **SQRT(3) .Vn** | **SQRT(3) .Vn** |
| **SQRT(3) .Vn** | **SQRT(3) .Vn** | **SQRT(3) .Vn** |
| SQRT(3) .Vn | SQRT(3) .Vn | SQRT(3) .Vn |
| SQRT(3) .Vn | SQRT(3) .Vn | SQRT(3) .Vn |
| SQRT(3) .Vn | SQRT(3) .Vn | SQRT(3) .Vn |
| **[0;SQRT(3).Vn]** | **SQRT(3).Vn** | **[0;SQRT(3).Vn]** |
| Vn | SQRT(3).Vn | Vn |
| 0 | SQRT(3).Vn | SQRT(3) .Vn |
| SQRT(3) .Vn | SQRT(3) .Vn | 0 |
| **[0;Vn]** | **[0;Vn]** | **[0;Vn]** |
| 0 | [0;Vn] | [0;Vn] |
| [0;Vn] | [0;Vn] | Vn |
| [0;Vn] | Vn | [0;Vn] |
| 0 | Vn | Vn |

(suite)

| Tensions mesurées entre lignes | | |
|---|---|---|
| U'i | U'j | U'k |
| [0;Vn] | [0;Vn] | 0 |
| Vn | Vn | 0 |
| [0;Vn] | 0 | [0;Vn] |
| Vn | 0 | Vn |
| 0 | 0 | 0 |
| **[0;SQRT(3).Vn]** | **SQRT(3).Vn** | **[0;SQRT(3).Vn]** |
| [0;SQRT(3).Vn] | SQRT(3).Vn | [0;SQRT(3).Vn] |
| [0;SQRT(3).Vn] | SQRT(3).Vn | [0;SQRT(3).Vn] |
| 0 | SQRT(3).Vn | SQRT(3).Vn |
| [0;SQRT(3).Vn] | SQRT(3).Vn | [0;SQRT(3).Vn] |
| SQRT(3).Vn | SQRT(3).Vn | 0 |
| 0 | SQRT(3).Vn | SQRT(3).Vn |
| SQRT(3).Vn | SQRT(3).Vn | 0 |
| SQRT(3).Vn | SQRT(3).Vn | 0 |
| 0 | SQRT(3).Vn | SQRT(3).Vn |
| **Vn** | **SQRT(3).Vn** | **Vn** |

## Annexe 2

Le premier algorithme exploratoire est le suivant :

```
// Parameters
Vn = 230          //Vrms ; tension nominale
Tol_high = 10% // tolérance initiale sur la tension d'entrée
: Vn + Tol_high
Tol_low = 10%  // tolérance initiale sur la tension d'entrée
: Vn - Tol_low
Vdanger = 276  // Vrms ; seuil de tension considérée comme
dangereuse pour les équipements en aval
Vlow = 184          //Vrms  ;  tension  considérée  comme
anormalement basse
Voff = 30          //Vrms ; tension si basse qu'on l'assimile
comme une absence de phase
X = 1%                    //  pour  tenir  compte  notamment  de
l'incertitude 120° entre phase
Y = 1                    //V ; pour tenir compte notamment de
l'incertitude mesure tension
// Hypothèse : réseau triphasé 4 fils (3P+N) avec déphasage
entre phase fixe et constant à 120° (+/-(X/2)%)
// V[i] = tension RMS mesurée entre la phase_i & le neutre
sur la dernière seconde
```

```
// U[i] = tension RMS mesurée entre la phase_i & la phase_j
sur la dernière seconde
// A priori, prendre les mesures RMS fondamentales (50Hz)
loop every second
        NeutralConnectStatus = UNKNOWN
        PhaseConnectStatus[] = [UNKNOWN;UNKNOWN;UNKNOWN]
        PhaseVoltageStatus[] = [UNKNOWN;UNKNOWN;UNKNOWN]
        for i = 1 to 3
                a[i] = V[i]/Vref
        end for
        for i = 1 to 3
                j = i+1 %3
                // Calcul des tensions composées attendues
connaissant les tensions simples, si toutes les lignes sont
présentes (3P+N)
                Uprev[i] = Vref.SQRT(a[i]²+a[j]²+a[i].a[j])
                // Décompte des tensions composées mesurées
présentant une valeur anormale
                if ((U[i]<(Uprev[i]) or (U[i]>(Uprev[i]))) // if
((U[i]<(Uprev[i]-(2.Y))) or (U[i]>(Uprev[i]+(2.Y))))
                        abnormal[i] = 1
                else
                        abnormal[i] = 0
                end if
        end for
        if (sum(abnormal[])=0)
                // cas par défaut : toutes les lignes sont
présentes
                NeutralConnectStatus = CONNECTED
                PhaseConnectStatus[]                          =
[CONNECTED;CONNECTED;CONNECTED]
                // cas particulier : une phase présente une tension
```

extrêmement faible, qu'on assimile alors à une absence de phase

```
        for i = 1 to 3
            if (V[i]<Voff)
                PhaseConnectStatus[i] = DISCONNECTED
            end if
        end for
    end if
    if (sum(abnormal[])=1)
        // cas par défaut : perte du neutre uniquement (et
```
manifestement déséquilibre faible des charges avales)
```
        // NeutralConnectStatus = DISCONNECTED
        // cas par défaut (alternatif) : pas encore assez
```
signifiant pour déclarer une perte de neutre, on le considère encore comme potentiellement présent
```
        NeutralConnectStatus = CONNECTED
        PhaseConnectStatus[]                                    =
[CONNECTED;CONNECTED;CONNECTED]
        // contre-proposition : perte d'une phase
```
uniquement (ramenée entre l'une des phases restantes et le neutre)
```
        for i = 1 to 3
            j = i+1 %3
            k = i+2 %3
            if ((V[i]+U[i]=V[j]) or (V[i]+U[k]=V[k])) //
if ((V[i]+U[i]=V[j]+/-(2.Y)) or (V[i]+U[k]=V[k]+/-(2.Y)))
                NeutralConnectStatus = CONNECTED
                PhaseConnectStatus[i] = DISCONNECTED
                // traitement cas particulier de la
```
contre-proposition (obtenu si 1 phase est connectée sur une autre phase)
```
                if ((V[i]=V[j]) or (V[i]=V[k])) // if
```

```
            ((V[i]=V[j]+/-Y) or (V[i]=V[k]+/-Y))
                                PhaseConnectStatus[i] = CONNECTED
                    end if
                end if
            end for
        end if
        if (sum(abnormal[])=2)
            // cas par défaut : perte du neutre uniquement (et
manifestement déséquilibre faible des charges avales)
            // NeutralConnectStatus = DISCONNECTED
            // cas par défaut (alternatif) : pas encore assez
signifiant pour déclarer une perte de neutre, on le considère
encore comme potentiellement présent
            NeutralConnectStatus = CONNECTED
            PhaseConnectStatus[]                                =
[CONNECTED;CONNECTED;CONNECTED]
            // contre-proposition : perte d'une phase
uniquement (ramenée entre les 2 autres phases et le neutre)
            for i = 1 to 3
                j = i+1 %3
                k = i+2 %3
                if (((V[i]<V[j]) and (U[i]<V[j])) or
((V[i]<V[k]) and (U[k]<V[k]))) // if (((V[i]<V[j]+Y) and
(U[i]<V[j]+Y)) or ((V[i]<V[k]+Y) and (U[k]<V[k]+Y)))
                    NeutralConnectStatus = CONNECTED
                    PhaseConnectStatus[i] = DISCONNECTED
                end if
            end for
        end if
        if (sum(abnormal[])=3)
            // cas par défaut : perte du neutre uniquement (et
manifestement déséquilibre signifiant des charges avales)
```

```
NeutralConnectStatus = DISCONNECTED
PhaseConnectStatus[]                                    =
[CONNECTED;CONNECTED;CONNECTED]
        // contre-proposition 1 : perte du neutre et d'une
phase également (ramenées entre les 2 autres phases)
            for i = 1 to 3
                j = i+1 %3
                k = i+2 %3
                if ((V[j]+V[k]=U[j]) and (U[i]+U[k]=U[j])) //
if ((V[j]+V[k]=U[j]+/-(2.Y)) and (U[i]+U[k]=U[j]+/-(2.Y)))
                    PhaseConnectStatus[i] = DISCONNECTED
                    // traitement cas particulier de la
contre-proposition 1 (obtenu si 1 phase est connectée sur
une autre phase)
                    if ((U[i]=U[j]) or (U[k]=U[j])) // if
((U[i]=U[j]+/-(2.Y)) or (U[k]=U[j]+/-(2.Y)))
                        PhaseConnectStatus[i] = CONNECTED
                    end if
                end if
            end for
        // contre-proposition 2 : perte de 2 phases
uniquement (ramenées entre le neutre et la phase restante)
            for i = 1 to 3
                j = i+1 %3
                k = i+2 %3
                if ((V[i]+U[k]=V[k]) and (V[j]+U[j]=V[k])) //
if ((V[i]+U[k]=V[k]+/-(2.Y)) and (V[j]+U[j]=V[k]+/-(2.Y)))
                    NeutralConnectStatus = CONNECTED
                    PhaseConnectStatus[i] = DISCONNECTED
                    PhaseConnectStatus[j] = DISCONNECTED
                    // traitement cas particulier de la
contre-proposition 2 (obtenu si les 3 phases sont connectées
```

entre elles)

```
                        if ((V[i]=V[j]) and (V[i]=V[k])) // if
((V[i]=V[j]+/-Y) and (V[i]=V[k]+/-Y))
        PhaseConnectStatus[]=[CONNECTED;CONNECTED;CONNECTED]
                        end if
                    end if
                end for
                // contre-proposition 3 : inversion entre le
neutre et un phase sur le câblage du compteur
                for i = 1 to 3
                    j = i+1 %3
                    k = i+2 %3
                    // Calcul des tensions composées attendues
connaissant les tensions simples, si toutes les lignes sont
présentes (3P+N) et en supposant une inversion entre le
neutre et la phase i
                    a[i] = V[i]/Vref
                    a[j] = U[i]/Vref
                    a[k] = U[k]/Vref
                    Uprev_inv[i]                            =
Vref.SQRT(a[i]²+a[j]²+a[i].a[j])
                    Uprev_inv[j]                            =
Vref.SQRT(a[j]²+a[k]²+a[j].a[k])
                    Uprev_inv[k]                            =
Vref.SQRT(a[k]²+a[i]²+a[k].a[i])
                        if (Uprev_inv[]=[V[j];U[j];V[k])   //   if
(Uprev_inv[]=[V[j]+/-(2.Y);U[j]+/-(2.Y);V[k]+/-(2.Y))
                        NeutralConnectStatus                =
INVERTED_WITH_PHASE
                        PhaseConnectStatus[i]               =
INVERTED_WITH_NEUTRAL
                        PhaseConnectStatus[j] = CONNECTED
```

```
                    PhaseConnectStatus[k] = CONNECTED
            end if
        end for
    end if
    for i = 1 to 3
        // On donne un statut concernant les niveaux de
tension provenant du réseau
        if (NeutralConnectStatus = DISCONNECTED)
            PhaseVoltageStatus[i] = UNKNOWN
        elseif (PhaseConnectStatus[i] = DISCONNECTED)
            PhaseVoltageStatus[i] = UNKNOWN
        elseif (V[i]>Vdanger)
            PhaseVoltageStatus[i]                        =
DANGEROUS_OVERVOLTAGE
        elseif (V[i]>(1+Tol_high).Vn)
            PhaseVoltageStatus[i] = OVERVOLTAGE
        elseif (V[i]<(1-Tol_low).Vn)
            PhaseVoltageStatus[i] = UNDERVOLTAGE
        elseif (V[i]<Vlow)
            PhaseVoltageStatus[i] = DEEP_UNDERVOLTAGE
        else
            PhaseVoltageStatus[i] = NORMAL
        end if
        // On donne un statut concernant la dangerosité du
niveau de tension côté aval
    end for
    if (max(V[])>Vdanger)
        DownStreamVoltageDanger = TRUE
        // éventuellement ouvrir les breakers pour
protéger les équipements branchés en aval
    else
        DownStreamVoltageDanger = FALSE
```

```
end if

end loop
```

**Annexe 3**

Le deuxième algorithme exploratoire est le suivant :

```
// Parameters

Vn = 230          //in Vrms ; tension nominale

Tol_high = 10% // tolérance initiale sur la tension d'entrée
: Vn + Tol_high

Tol_low = 10%  // tolérance initiale sur la tension d'entrée
: Vn - Tol_low

Vdanger = 276  //in Vrms ; seuil de tension considérée comme
dangereuse pour les équipements en aval

Vlow = 184          //in  Vrms  ;  tension  consdérée  comme
anormalement basse

Voff = 30          //in Vrms ; tension si basse qu'on l'assimile
comme une absence de phase

Vmargin = 1          //in  V;  afin  de  tenir  compte  de
l'incertitude de mesure

Aref = 120          //in °; angle de déphasage nominal entre
phases

Atolgrd = 1          //in  °;  afin  de  tenir  compte  de  la
tolérance initiale du réseau électrique

Atolmeas = 3   //in °; afin de tenir compte de l'incertitude
de mesure

Amargin = Atolgrd + Atolmeas

Alow          =          2.acos(((1+Tol_high).Vn)²-((1-
Tol_low).Vn).((1+Tol_high).Vn).cos(Aref))/(((1+Tol_high).Vn
).SQRT(((1-Tol_low).Vn)²+((1+Tol_high).Vn)²-2.((1-
Tol_low).Vn).((1+Tol_high).Vn).cos(Aref))))

                    // l'angle entre les vecteurs phase-
phase et phase-phase (par exemple U12 à U13) est nominalement
de 60° ((180°-Aref)/2) si l'on considère des niveaux de
```

tension parfaitement équilibrés


// Alow est l'angle le plus bas entre les vecteurs phase-phase et phase-phase, compte tenu des tolérances initiales sur les tensions de ligne


// Alow est l'angle mesurable le plus bas prévu en cas de perte du neutre (phases restant toutes connectées)


Ahigh = 2.acos((((1-Tol_low).Vn)$^2$-((1+Tol_high).Vn).((1-Tol_low).Vn).cos(Aref))/(((1-Tol_low).Vn).SQRT(((1+Tol_high).Vn)$^2$+((1-Tol_low).Vn)$^2$-2.((1+Tol_high).Vn).((1-Tol_low).Vn).cos(Aref))))
// l'angle entre les vecteurs phase-phase et phase-phase (par exemple U12 à U13) est nominalement de 60° ((180°-Aref)/2) si l'on considère des niveaux de tension parfaitement équilibrés


// Ahigh est l'angle le plus élevé entre les vecteurs phase-phase et phase-phase, compte tenu des tolérances initiales sur les tensions de ligne.


// Hypothèse : Réseau 4 fils (3P+N) avec angles entre phases fixes et constants à Aref (120°)
// V[i] = tension efficace mesurée entre phase_i et neutre durant la dernière seconde
// A[i] = angle mesuré entre phase_i & phase_j pendant la dernière seconde, valeur comprise entre ]-180°;180°]
// NB : les déclarations "if" doivent être implémentées avec

les marges sur les seuils (c'est à dire celles définies dans le commentaire ci-dessous)

```
loop (every_second)
        NeutralConnectStatus = UNKNOWN
        PhaseConnectStatus[] = [UNKNOWN;UNKNOWN;UNKNOWN]
        PhaseVoltageStatus[] = [UNKNOWN;UNKNOWN;UNKNOWN]
        ConnectDirection = UNKNOWN

        //
```
Patch en cas d'absence de tension alternative d'entrée (par exemple lors d'une coupure de courant ou d'une micro-panne du réseau, d'un compteur fonctionnant sur sa réserve d'énergie interne ou de certaines conditions de laboratoire de R&D)

```
        if ((V[1]<Voff) and (V[2]<Voff) and (V[3]<Voff))
            BREAK // algorithm is inhibited
        end if
        //
```
si la tension est trop faible, l'angle est considéré comme non fiable à mesurer et donc forcé à 0°

```
        for i = 1 to 3
            j = i+1 %3
            k = i+2 %3
            if (V[i]<Voff)
                A[i] = 0
                A[k] = 0
            end if
        end for
        // Cas d'étude : toutes les lignes connectées
        if  (A[]=[Aref;Aref;Aref])  //  if  A[]=[Aref+/-
Amargin;Aref+/-Amargin;Aref+/-Amargin]
            NeutralConnectStatus = CONNECTED
```

```
            PhaseConnectStatus[]                                    =
[CONNECTED;CONNECTED;CONNECTED]
            ConnectDirection = DIRECT
        end if
        if  (A[]=[-Aref;-Aref;-Aref])   //   if   A[]=[-Aref+/-
Amargin;-Aref+/-Amargin;-Aref+/-Amargin]
            NeutralConnectStatus = CONNECTED
            PhaseConnectStatus[]                                    =
[CONNECTED;CONNECTED;CONNECTED]
            ConnectDirection = INDIRECT
        end if
        // Cas d'étude : inversion d'une ligne neutre et d'une
ligne phase sur les connexions aux bornes
        if (NeutralConnectStatus = UNKNOWN)
            for i = 1 to 3
                j = i+1 %3
                k = i+2 %3
                if       ((Alow/2<=-A[i]<=Ahigh/2)        and
(Alow<=A[j]<=Ahigh)   and   (Alow/2<=-A[k]<=Ahigh/2))   //   if
(((Alow/2-Amargin)<=-A[i]<=(Ahigh/2+Amargin))   and   ((Alow-
Amargin)<=A[j]<=(Ahigh+Amargin))   and   ((Alow/2-Amargin)<=-
A[k]<=(Ahigh/2+Amargin)))
                    NeutralConnectStatus                           =
INVERTED_WITH_PHASE
                    PhaseConnectStatus[i]                          =
INVERTED_WITH_NEUTRAL
                    PhaseConnectStatus[j] = CONNECTED
                    PhaseConnectStatus[k] = CONNECTED
                    ConnectDirection = DIRECT
                elseif ((Alow/2<=A[i]<=Ahigh/2) and (Alow<=-
A[j]<=Ahigh) and (Alow/2<=A[k]<=Ahigh/2)) // if (((Alow/2-
Amargin)<=A[i]<=(Ahigh/2+Amargin))   and   ((Alow-Amargin)<=-
```

```
A[j]<=(Ahigh+Amargin))                    and                    ((Alow/2-
Amargin)<=A[k]<=(Ahigh/2+Amargin)))
                         NeutralConnectStatus                              =
INVERTED_WITH_PHASE
                         PhaseConnectStatus[i]                             =
INVERTED_WITH_NEUTRAL
                         PhaseConnectStatus[j] = CONNECTED
                         PhaseConnectStatus[k] = CONNECTED
                         ConnectDirection = INDIRECT
            end for
        end if
        // Cas d'étude : 1 phase déconnectée (2 autres phases
et neutre toujours connectés)
        if (NeutralConnectStatus = UNKNOWN)
            for i = 1 to 3
                j = i+1 %3
                k = i+2 %3
                if ((A[i]=Aref) and (-Aref<=A[j]<=0) and (-
Aref<=A[k]<=0))  // if ((A[i]=Aref+/-Amargin) and (-Aref-
Amargin<=A[j]<=0+Amargin)             and             (-Aref-
Amargin<=A[k]<=0+Amargin))
                         NeutralConnectStatus = CONNECTED
                         ConnectDirection = DIRECT
                end if
                if ((A[i]=-Aref) and (0<=A[j]<=Aref) and
(0<=A[k]<=Aref))  //  if  ((A[i]=-Aref+/-Amargin)  and  (0-
Amargin<=A[j]<=Aref+Amargin)            and            (0-
Amargin<=A[k]<=Aref+Amargin))
                         NeutralConnectStatus = CONNECTED
                         ConnectDirection = INDIRECT
                end if
            end for
```

```
if (NeutralConnectStatus = CONNECTED)
    for i = 1 to 3
        j = i+1 %3
        k = i+2 %3
        if (V[i]<Voff)
            PhaseConnectStatus[i]                =
DISCONNECTED
        elseif ((ConnectDirection=DIRECT) and
((A[i]=Aref)   or   (A[k]=Aref)))        //        elseif
((ConnectDirection=DIRECT) and ((A[i]=Aref+/-Amargin) or
(A[k]=Aref+/-Amargin)))
            PhaseConnectStatus[i] = CONNECTED
        elseif ((ConnectDirection=INDIRECT) and
((A[i]=-Aref)   or   (A[k]=-Aref)))       //       elseif
((ConnectDirection=INDIRECT) and ((A[i]=-Aref+/-Amargin) or
(A[k]=-Aref+/-Amargin)))
            PhaseConnectStatus[i] = CONNECTED
        elseif (A[i]=0)   //   elseif   (A[i]=0+/-
Amargin)
            if (V[i]<V[j])   //   if   (V[i]<V[j]-
Vmargin)
                PhaseConnectStatus[i]                =
DISCONNECTED
            else
                // phase   i   considered   as
connected to phase j
                PhaseConnectStatus[i]                =
CONNECTED
            end if
        elseif (A[k]=0)
            if (V[i]<V[k])   //   if   (V[i]<V[k]-
Vmargin)
```

```
                              PhaseConnectStatus[i]           =
DISCONNECTED
                        else
                              // phase  i  considered  as
connected to phase k
                              PhaseConnectStatus[i]           =
CONNECTED
                        end if
                  else
                        PhaseConnectStatus[i]                 =
DISCONNECTED
                  end if
            end for
      end if
end if
//
Cas  d'étude  :  neutre  déconnecté  (3  phases  toujours
connectées)


if (NeutralConnectStatus = UNKNOWN)
      for i = 1 to 3
            if   (Alow<=A[i]<Aref)   //   if   (Alow-
Amargin<=A[i]<Aref-Amargin)
                  NeutralConnectStatus = DISCONNECTED
                  ConnectDirection = DIRECT
            end if
            if   (-Aref<A[i]<=-Alow)   //   if   (-
Aref+Amargin<A[i]<=-Alow+Amargin)
                  NeutralConnectStatus = DISCONNECTED
                  ConnectDirection = INDIRECT
            end if
      end for
```

```
        if (NeutralConnectStatus = DISCONNECTED)
            PhaseConnectStatus[]                              =
[CONNECTED;CONNECTED;CONNECTED]
            end if
        end if


        // Ne représente pas un cas pratique prévu ; les
critères de détection indiqués ci-dessous ne sont pas
corrects ; les critères appropriés ne sont pas faciles à
définir ; cas d'étude par conséquent abandonné
// // Cas d'étude (peu probable) : neutre et 1 phase "quasi-
déconnectés" (lignes impédantes) (2 autres phases toujours
connectées)// if (NeutralConnectStatus = UNKNOWN)
//        for i = 1 to 3
//                j = i+1 %3
//                k = i+2 %3
//            if ((0<A[i]<Alow) and (A[j]>Aref) and
(A[k]>Aref)) // if ((0+Amargin<A[i]<Alow-Amargin) and
(A[j]>Aref+Amargin) and (A[k]>Aref+Amargin))
//                    NeutralConnectStatus = DISCONNECTED
//                    PhaseConnectStatus[i] = DISCONNECTED
//                    PhaseConnectStatus[j] = CONNECTED
//                    PhaseConnectStatus[k] = CONNECTED
//        end for
//    end if
        // Cas d'étude : 2 lignes déconnectées (2 autres lignes
toujours connectées)
        if (NeutralConnectStatus = UNKNOWN)
            if (A[]=[0;0;0]) // if (A[]=[0+/-Amargin;0+/-
Amargin;0+/-Amargin])
                // pour discriminer si nous sommes confrontés
à une perte neutre ou non
```

```
            for i = 1 to 3
                    if (V[i]>(1+0.3).Vn)  // Vn+30% chosen
because it is the "middle" between (Vn+20%) and SQRT(3).(Vn-
20%)
                            NeutralConnectStatus            =
DISCONNECTED
                    end if
            end for
            if (NeutralConnectStatus = UNKNOWN)
                    NeutralConnectStatus = CONNECTED
            end if
            // Cas d'étude : 2 phases déconnectées (neutre
et autre phase restant toujours connectée)
            if (NeutralConnectStatus = CONNECTED)
                    for i = 1 to 3
                            j = i+1 %3
                            k = i+2 %3
                            if ((V[i]<V[j]) and (V[i]<V[k])) //
if ((V[i]<V[j]-Vmargin) and (V[i]<V[k]-Vmargin))
                                    PhaseConnectStatus[i]      =
DISCONNECTED
                            else

        // la phase i est la plus élevée, donc celle
connectée
// éventuellement plusieurs phases peuvent finalement être
considérées comme connectées ici, ce qui se produirait si
elles étaient connectées ensemble
        PhaseConnectStatus[i] = CONNECTED
                            end if
                    end for
            end if
```

```
                    // Cas d'étude : neutre et 1 phase déconnectés
(2 autres phases toujours connectées) (1)
                    if (NeutralConnectStatus = DISCONNECTED)
                        for i = 1 to 3
                            j = i+1 %3
                            k = i+2 %3
                            if ((V[i]<V[j]) and (V[i]<V[k])) //
if ((V[i]<V[j]-Vmargin) and (V[i]<V[k]-Vmargin))
                                // la phase i est la plus
basse, donc connectée
                                PhaseConnectStatus[i]       =
CONNECTED
                            elseif      ((V[i]>V[j])      and
(V[i]>V[k]))    //    elseif    ((V[i]>V[j]+Vmargin)    and
(V[i]>V[k]+Vmargin))
                                // phase i is the higher, thus
a connected one
                                PhaseConnectStatus[i]       =
CONNECTED
                            elseif ((V[i]=V[j]) or (V[i]=V[k]))
// elseif ((V[i]=V[j]+/-Vmargin) or (V[i]=V[k]+/-Vmargin))
                                // finalement la troisième
phase peut enfin être considérée comme connectée, ce qui se
produirait si la phase i était connectée à la phase j ou k
                                PhaseConnectStatus[i]       =
CONNECTED
                            else
                                PhaseConnectStatus[i]       =
DISCONNECTED
                            end if
                        end for
                    end if
```

```
        end if
        // Cas d'étude : neutre et 1 phase déconnectés (2
autres phases toujours connectées) (2)
            if (NeutralConnectStatus = UNKNOWN)
                for i = 1 to 3
                    j = i+1 %3
                    k = i+2 %3
                    if (A[i]=0) // if (A[i]=0+/-Amargin)
                        NeutralConnectStatus              =
DISCONNECTED
                        if   (A[k]=0)   //   if   (A[k]=0+/-
Amargin)
                            PhaseConnectStatus[i]         =
DISCONNECTED
                            PhaseConnectStatus[j]         =
CONNECTED
                            PhaseConnectStatus[k]         =
CONNECTED
                        elseif   (V[i]<V[j])   //   elseif
(V[i]<V[j]-Vmargin)
                            PhaseConnectStatus[i]         =
DISCONNECTED
                            PhaseConnectStatus[j]         =
CONNECTED
                            PhaseConnectStatus[k]         =
CONNECTED
                        elseif   (V[j]<V[i])   //   elseif
(V[j]<V[i]-Vmargin)
                            PhaseConnectStatus[i]         =
CONNECTED
                            PhaseConnectStatus[j]         =
DISCONNECTED
```

```
                              PhaseConnectStatus[k]         =
CONNECTED
                      else // V[i]=V[j]+/-Vmargin
                              PhaseConnectStatus[i]         =
CONNECTED
                              PhaseConnectStatus[j]         =
CONNECTED
                              PhaseConnectStatus[k]         =
CONNECTED
                          end if
                      end if
                  end for
              end if
          end if    // Tous les cas d'études pratiques auraient
dû être couverts à ce stade
// En cas de cas d'étude pratique imprévu :  if
(NeutralConnectStatus = UNKNOWN)
              NeutralConnectStatus = CONNECTED // or UNKNOWN, as
preferred
              PhaseConnectStatus[]                          =
[CONNECTED;CONNECTED;CONNECTED]              //              or
[UNKNOWN;UNKNOWN;UNKNOWN], as preferred
              ConnectDirection = DIRECT // or UNKNOWN, as
preferred
              UnexpectedSituation = TRUE
          else
              UnexpectedSituation = FALSE
          end if
          // Donnons ici un statut concernant les niveaux de
tension provenant du réseau
          for i = 1 to 3
              if (NeutralConnectStatus = DISCONNECTED)
```

```
                PhaseVoltageStatus[i] = UNKNOWN
          elseif (PhaseConnectStatus[i] = DISCONNECTED)
                PhaseVoltageStatus[i] = UNKNOWN
          elseif (V[i]>Vdanger)
                PhaseVoltageStatus[i]                    =
DANGEROUS_OVERVOLTAGE
          elseif (V[i]>(1+Tol_high).Vn)
                PhaseVoltageStatus[i] = OVERVOLTAGE
          elseif (V[i]<(1-Tol_low).Vn)
                PhaseVoltageStatus[i] = UNDERVOLTAGE
          elseif (V[i]<Vlow)
                PhaseVoltageStatus[i] = DEEP_UNDERVOLTAGE
          else
                PhaseVoltageStatus[i] = NORMAL
          end if
      end for
      // Donnons ici un statut de la dangerosité du niveau de
tension en aval
      if (max(V[])>Vdanger)
          DownStreamVoltageDanger = TRUE
          // éventuellement ouvrir ici les disjoncteurs pour
protéger les équipements connectés côté aval
      else
          DownStreamVoltageDanger = FALSE
      end if
  end loop
```

**Revendications**

1. Procédé de surveillance d'un réseau électrique polyphasé (6), mis en oeuvre au moins partiellement dans une unité de traitement (15) d'un équipement électrique (5) connecté au réseau électrique polyphasé, et comprenant les étapes, répétées régulièrement, de :

   - acquérir des mesures de tensions réalisées par des capteurs de tension ($R_{1A}$, $R_{1B}$, $R_{2A}$, $R_{2B}$, $R_{3A}$, $R_{3B}$) de l'équipement électrique qui sont reliés au réseau électrique polyphasé ;
   - produire, à partir des mesures de tension, des valeurs courantes de paramètres électriques ;
   - accéder à une table de référence (20), qui comprend une liste de configurations de connexion associées chacune à une combinaison distincte de valeurs de référence desdits paramètres électriques, la liste de configurations de connexion comprenant des premières configurations de connexion correspondant chacune à une combinaison distincte d'états de connexion ou de déconnexion pour chaque phase (P1, P2, P3) et pour le neutre (N) ;
- mettre en oeuvre un algorithme exploratoire, destiné à explorer la table de référence (20) pour identifier la configuration de connexion associée aux valeurs courantes des paramètres électriques.

2. Procédé de surveillance selon la revendication 1, dans lequel la liste de configurations de connexion comprend des deuxièmes configurations de connexion correspondant chacune, pour l'une des phases (P1, P2, P3), à une inversion du neutre (N) et de ladite phase (P1, P2, P3).

3. Procédé de surveillance selon l'une des revendications précédentes, dans lequel la liste de configurations de connexion comprend des troisièmes configurations de connexion correspondant chacune à l'une des phases qui est déconnectée et qui se retrouve mise au potentiel d'une autre phase.

4. Procédé de surveillance selon l'une des revendications précédentes, dans lequel la mise en oeuvre de l'algorithme exploratoire comprend les étapes de :

- tester une configuration de connexion, en vérifiant si des critères prédéterminés associés à ladite configuration de connexion sont remplis, les critères prédéterminés étant définis à partir des paramètres électriques ;
- si les critères prédéterminés sont remplis, en déduire que ladite configuration de connexion est celle qui correspond aux valeurs courantes des paramètres électriques ;
- sinon, réitérer l'étape de test avec une autre configuration de connexion.

5. Procédé de surveillance selon l'une des revendications précédentes, dans lequel les paramètres électriques comprennent :

- des tensions simples mesurées, chaque tension simple mesurée étant représentative d'une amplitude d'une tension simple ($\vec{V'_1}, \vec{V'_2}, \vec{V'_3}$) entre l'une des phases et le neutre, et/ou
- des tensions composées mesurées, chaque tension composée mesurée étant représentative d'une amplitude d'une tension composée ($\vec{U'_1}, \vec{U'_2}, \vec{U'_3}$) entre deux phases distinctes, et/ou

- des angles mesurés ($Phi_1$, $Phi_2$, $Phi_3$), chaque angle mesuré étant égal à un angle entre une représentation vectorielle d'une tension simple entre une phase et le neutre, et entre une représentation vectorielle d'une tension simple entre une autre phase et le neutre.

6. Procédé de surveillance selon la revendication 5, dans lequel les angles mesurés sont obtenus en mettant en oeuvre une méthode de détection de passage à zéro sur les tensions mesurées entre les phases et le neutre.

7. Procédé de surveillance selon la revendication 5, dans lequel l'algorithme exploratoire mis en oeuvre est un premier algorithme exploratoire qui utilise uniquement, comme paramètres électriques, les tensions simples mesurées et les tensions composées mesurées.

8. Procédé de surveillance selon les revendications 4 et 7, dans lequel le premier algorithme exploratoire comprend l'étape de tenter de détecter une ou des tensions composées mesurées qui sont anormales, le premier algorithme exploratoire consistant alors à tester des ensembles de configurations de connexion, qui sont définis en fonction du nombre de tensions composées mesurées anormales.

9. Procédé de surveillance selon la revendication 8, dans lequel la tension composée mesurée $U'_i$ est considérée comme anormale si :

$$U'_i < Uprev_i - \alpha \text{ ou si } U'_i > Uprev_i + \alpha,$$

où :

$\alpha$ est une marge d'incertitude,
et où :

$$\mathtt{Uprev_i \ = \ V_n.SQRT(ai^2+aj^2+ai.aj),}$$

où $ai = V_i/V_n$, $aj = V_j/V_n$, $V_i$ est la tension simple mesurée pour la phase Pi, $V_j$ est la tension simple mesurée pour la phase Pj, et $V_n$ est une tension simple nominale.

10. Procédé de surveillance selon les revendications 4 et 7, dans lequel les critères prédéterminés comprennent des comparaisons réalisées chacune entre :

- une tension résultante, obtenue en sommant :

  ◦ deux tensions simples mesurées différentes, ou
  ◦ une tension simple mesurée et une tension composée mesurée,

- et une tension simple mesurée ou une tension composée mesurée.

11. Procédé de surveillance selon la revendication 5, dans lequel l'algorithme exploratoire mis en oeuvre est un deuxième algorithme exploratoire qui utilise uniquement, comme paramètres électriques, les tensions simples mesurées et les angles mesurés.

12. Procédé de surveillance selon les revendications 2, 4 et 11, dans lequel les critères prédéterminés, associés aux configurations de connexion suivantes, comprennent uniquement des comparaisons entre les angles mesurés et des seuils angulaires :

   - le neutre et toutes les phases sont normalement connectés ;
   - le neutre est inversé avec l'une des phases ;
   - le neutre est déconnecté et toutes les phases sont connectées.

13. Procédé de surveillance selon la revendication 11, dans lequel le deuxième algorithme exploratoire teste si un câblage des phases à l'équipement électrique est réalisé selon un ordre direct ou indirect.

14. Equipement électrique comprenant des capteurs de tension et une unité de traitement (15) dans laquelle est mis en oeuvre le procédé de surveillance selon l'une des revendications précédentes.

15. Equipement électrique selon la revendication 14, l'équipement électrique étant un compteur.

16. Programme d'ordinateur comprenant des instructions qui conduisent l'unité de traitement (15) de l'équipement électrique selon l'une des revendications 14 ou 15 à exécuter les étapes du procédé de surveillance selon l'une des revendications 1 à 13.

17. Support d'enregistrement lisible par ordinateur, sur lequel est enregistré le programme d'ordinateur selon la revendication 16.

**Patentansprüche**

1. Verfahren zur Überwachung eines mehrphasigen Stromnetzes (6), das zumindest teilweise in einer Verarbeitungseinheit (15) eines mit dem mehrphasigen Stromnetz verbundenen, elektrischen Geräts (5) ausgeführt wird, und die regelmäßig wiederholten Schritte umfasst, dass:

   - Spannungsmessungen erfasst werden, die von Spannungssensoren ($R_{1A}$, $R_{1B}$, $R_{2A}$, $R_{2B}$, $R_{3A}$, $R_{3B}$) des mit dem mehrphasigen Stromnetz verbundenen, elektrischen Geräts durchgeführt wurden;
   - aus den Spannungsmessungen aktuelle Werte für elektrische Parameter erzeugt werden;
   - auf eine Referenztabelle (20) zugegriffen wird, die eine Liste von Verbindungskonfigurationen umfasst, denen jeweils eine distinkte Kombination von Referenzwerten der elektrischen Parameter zugeordnet ist, wobei die Liste von Verbindungskonfigurationen erste Verbindungskonfigurationen umfasst, die jeweils einer distinkten Kombination von Verbindungs- oder Trennungszuständen für jede Phase (P1, P2, P3) und für den Neutralleiter (N) entsprechen;

- ein Erkundungs-Algorithmus zur Durchsuchung der Referenztabelle (20) ausgeführt wird, um die den aktuellen Werten der elektrischen Parameter zugeordnete Verbindungskonfiguration zu identifizieren.

2. Überwachungsverfahren nach Anspruch 1, wobei die Liste von Verbindungskonfigurationen zweite Verbindungs-konfiguration umfasst, die jeweils für eine der Phasen (P1, P2, P3) einer Inversion des Neutralleiters (N) mit der betreffenden Phase (P1, P2, P3) entsprechen.

3. Überwachungsverfahren nach einem der vorhergehenden Ansprüche, wobei die Liste von Verbindungskonfigurationen dritte Verbindungskonfigurationen umfasst, die jeweils einer der Phasen entsprechen, die abgetrennt ist und auf dem Potenzial einer anderen Phase liegt.

4. Überwachungsverfahren nach einem der vorhergehenden Ansprüche, wobei die Ausführung des Erkundungs-Algorithmus die Schritte umfasst, dass:

   - eine Verbindungskonfiguration getestet wird, indem überprüft wird, ob vorbestimmte, der betreffenden Verbindungskonfiguration zugeordnete Kriterien erfüllt sind, wobei die vorbestimmten Kriterien auf Basis der elektrischen Parameter definiert werden;
   - wenn die vorbestimmten Kriterien erfüllt sind, daraus abgeleitet wird, dass es sich bei der Verbindungskonfiguration um diejenige handelt, die den aktuellen Werten der elektrischen Parameter entspricht;
   - wenn dies nicht der Fall ist, der Testschritt mit einer anderen Verbindungskonfiguration wiederholt wird.

5. Überwachungsverfahren nach einem der vorhergehenden Ansprüche, wobei die elektrischen Parameter Folgendes umfassen:

   - gemessene einfache Spannungen, wobei jede gemessene einfache Spannung eine Amplitude einer einfachen Spannung ($\vec{V_1}, \vec{V_2}, \vec{V_3}$) zwischen einer der Phasen und dem Neutralleiter darstellt, und/oder
   - gemessene zusammengesetzte Spannungen, wobei jede gemessene zusammengesetzte Spannung eine Amplitude einer zusammengesetzten Spannung ($\vec{U_1}, \vec{U_2}, \vec{U_3}$) zwischen zwei unterschiedlichen Phasen darstellt, und/oder
   - gemessene Winkel ($Phi_1$, $Phi_2$, $Phi_3$), wobei jeder gemessene Winkel gleich einem Winkel zwischen einer Vektordarstellung einer einfachen Spannung zwischen einer Phase und dem Neutralleiter, und zwischen einer Vektordarstellung einer einfachen Spannung zwischen einer anderen Phase und dem Neutralleiter ist.

6. Überwachungsverfahren nach Anspruch 5, wobei die gemessenen Winkel unter Anwendung einer Methode zur Detektion von Nulldurchgängen auf die gemessenen Spannungen zwischen den Phasen und dem Neutralleiter gewonnen werden.

7. Überwachungsverfahren nach Anspruch 5, wobei es sich bei dem ausgeführten Erkundungs-Algorithmus um einen ersten Erkundungs-Algorithmus handelt, der als elektrische Parameter ausschließlich die gemessenen einfachen Spannungen und die gemessenen zusammengesetzten Spannungen verwendet.

8. Überwachungsverfahren nach den Ansprüchen 4 und 7, wobei der erste Erkundungs-Algorithmus den Schritt umfasst, dass versucht wird, eine oder mehrere gemessene zusammengesetzte Spannungen zu erkennen, die anormal sind, wobei der erste Erkundungs-Algorithmus darin besteht, Sätze von Verbindungskonfigurationen zu testen, die anhand der Anzahl der anormalen gemessenen zusammengesetzten Spannungen definiert sind.

9. Überwachungsverfahren nach Anspruch 8, wobei die gemessene zusammengesetzte Spannung U'$_i$ als anormal zu betrachten ist, wenn:

   U'$_i$ < Uprev$_i$ - $\alpha$ oder wenn U'$_i$ > Uprev$_i$ + $\alpha$,
   wobei:

   $\alpha$ eine Unsicherheitsspanne ist,
   und wobei:

$$Uprev_i = V_n.SQRT(ai^2+aj^2+ai.aj),$$

wobei ai = $V_i/V_n$, aj = $V_j/V_n$, $V_i$ die gemessene einfache Spannung für die Phase Pi ist, $V_j$ die gemessene einfache Spannung für die Phase Pj ist, und $V_n$ eine einfache Nominalspannung ist.

10. Überwachungsverfahren nach den Ansprüchen 4 und 7, wobei die vorbestimmten Kriterien Vergleiche umfassen, die jeweils durchgeführt werden zwischen:

   - einer resultierenden Spannung, gewonnen durch Aufsummieren von:

      ∘ zwei verschiedenen gemessenen einfachen Spannungen, oder
      ∘ einer gemessenen einfachen Spannung und einer gemessenen zusammengesetzten Spannung,

   - und einer gemessenen einfachen Spannung oder einer gemessenen zusammengesetzten Spannung.

11. Überwachungsverfahren nach Anspruch 5, wobei es sich bei dem ausgeführten Erkundungs-Algorithmus um einen zweiten Erkundungs-Algorithmus handelt, der als elektrische Parameter ausschließlich die gemessenen einfachen Spannungen und die gemessenen Winkel verwendet.

12. Überwachungsverfahren nach den Ansprüchen 2, 4 und 11, wobei die den folgenden Verbindungskonfigurationen zugeordneten, vorbestimmten Kriterien ausschließlich Vergleiche zwischen den gemessenen Winkeln und Winkelschwellenwerten umfassen:

   - der Neutralleiter und alle Phasen sind fachgerecht verbunden;
   - der Neutralleiter ist mit einer der Phasen vertauscht;
   - der Neutralleiter ist abgetrennt und alle Phasen sind verbunden.

13. Überwachungsverfahren nach Anspruch 11, wobei der zweite Erkundungs-Algorithmus überprüft, ob eine Verdrahtung der Phasen zu dem elektrischen Gerät in direkter oder indirekter Reihenfolge realisiert ist.

14. Elektrisches Gerät umfassend Spannungssensoren und eine Verarbeitungseinheit (15), in welcher das Überwachungsverfahren nach einem der vorhergehenden Ansprüche ausgeführt wird.

15. Elektrisches Gerät nach Anspruch 14, wobei es sich bei dem elektrischen Gerät um einen Zähler handelt.

16. Computerprogramm, das Befehle umfasst, welche die Verarbeitungseinheit (15) des elektrischen Geräts nach einem der Ansprüche 14 oder 15 dazu veranlassen, die Schritte des Überwachungsverfahrens nach einem der Ansprüche 1 bis 13 auszuführen.

17. Computerlesbares Speichermedium, auf welchem das Computerprogramm nach Anspruch 16 abgespeichert ist.

**Claims**

1. A method for monitoring a polyphase electricity network (6), implemented at least partially in a processing unit (15) of an item of electrical equipment (5) connected to the polyphase electricity network, and comprising the steps, repeated regularly, of:

   - acquiring voltage measurements taken by voltage sensors ($R_{1A}$, $R_{1B}$, $R_{2A}$, $R_{2B}$, $R_{3A}$, $R_{3B}$) of the item of electrical equipment that are connected to the polyphase electricity network;
   - producing current values of electrical parameters from the voltage measurements;
   - accessing a reference table (20) that comprises a list of connection configurations each associated with a distinct combination of reference values of said electrical parameters, the list of connection configurations comprising first connection configurations each corresponding to a distinct combination of connection or disconnection states for each phase (P1, P2, P3) and for the neutral (N);
   - implementing an exploratory algorithm intended to explore the reference table (20) to identify the connection configuration associated with the current values of the electrical parameters.

2. A monitoring method according to claim 1, in which the list of connection configurations comprises second connection configurations each corresponding, for one of the phases (P1, P2, P3), to an inversion of the neutral (N) and said phase (P1, P2, P3).

3. A monitoring method according to one of the preceding claims, in which the list of connection configurations comprises third connection configurations each corresponding to one of the phases that is disconnected and that is at the potential of another phase.

4. A monitoring method according to one of the preceding claims, in which the implementation of the exploratory algorithm comprises the steps of:

   - testing a connection configuration, by checking whether predetermined criteria associated with said connection configuration are fulfilled, the predetermined criteria being defined based on the electrical parameters;
   - if the predetermined criteria are fulfilled, deducing therefrom that said connection configuration is that which corresponds to the current values of the electrical parameters,
   - if not, repeating the testing step with another connection configuration.

5. A monitoring method according to one of the preceding claims, in which the electrical parameters comprise:

   - measured line-to-neutral voltages, each measured line-to-neutral voltage being representative of an amplitude of a line-to-neutral voltage ($\overrightarrow{V'_1}, \overrightarrow{V'_2}, \overrightarrow{V'_3}$) between one of the phases and the neutral; and/or
   - measured line-to-line voltages, each measured line-to-line voltage being representative of an amplitude of a line-to-line voltage ($\overrightarrow{U'_1}, \overrightarrow{U'_2}, \overrightarrow{U'_3}$)) between two distinct phases; and/or
   - measured angles ($Phi_1$, $Phi_2$, $Phi_3$), each measured angle being equal to an angle between a vector representation of a line-to-neutral voltage between one phase and the neutral, and a vector representation of a line-to-neutral voltage between another phase and the neutral.

6. A monitoring method according to claim 5, in which the measured angles are obtained by implementing a zero-crossing detection method on the voltages measured between the phases and the neutral.

7. A monitoring method according to claim 5, in which the exploratory algorithm implemented is a first exploratory algorithm that only uses the measured line-to-neutral voltages and the measured line-to-line voltages as electrical parameters.

8. A monitoring method according to claims 4 and 7, in which the first exploratory algorithm comprises the step of attempting to detect one or more measured line-to-line voltages that are abnormal, the first exploratory algorithm then consisting in testing sets of connection configurations, which are defined as a function of the number of abnormal measured line-to-line voltages.

9. A monitoring method according to claim 8, in which the measured line-to-line voltage $U'_i$ is considered to be abnormal if:

$$U'_i < Uprev_i - \alpha \text{ or if } U'_i > Uprev_i + \alpha,$$

where:

$\alpha$ is a margin of uncertainty,
and where:

$$Uprev_i = V_n.SQRT(ai^2+aj^2+ai.aj),$$

where $ai = V_i/V_n$, $aj = V_j/V_n$, $V_i$ is the measured line-to-neutral voltage for the phase Pi, $V_j$ is the measured line-to-neutral voltage for the phase Pj, and $V_n$ is a nominal line-to-neutral voltage.

10. A monitoring method according to claims 4 and 7, in which the predetermined criteria comprise comparisons each made between:

- a resulting voltage obtained by adding:

∘ two different measured line-to-neutral voltages; or
∘ a measured line-to-neutral voltage and a measured line-to-line voltage;

- and a measured line-to-neutral voltage or a measured line-to-line voltage.

11. A monitoring method according to claim 5, in which the exploratory algorithm implemented is a second exploratory algorithm that only uses the measured line-to-neutral voltages and the measured angles as electrical parameters.

12. A monitoring method according to claims 2, 4 and 11, in which the predetermined criteria, associated with the following connection configurations, only comprise comparisons between the measured angles and angular thresholds:

- the neutral and all the phases are normally connected;
- the neutral is inverted with one of the phases;
- the neutral is disconnected and all the phases are connected.

13. A monitoring method according to claim 11, in which the second exploratory algorithm tests whether the phases are wired to the item of electrical equipment in a direct or indirect order.

14. An item of electrical equipment comprising voltage sensors and a processing unit (15) in which the monitoring method according to one of the preceding claims is implemented.

15. An item of electrical equipment according to claim 14, the item of electrical equipment being a meter.

16. A computer program comprising instructions that cause the processing unit (15) of the item of electrical equipment according to one of claims 14 or 15 to perform the steps of the monitoring method according to one of steps 1 to 13.

17. A computer-readable storage medium on which the computer program according to claim 16 is stored.

Fig. 1

Fig. 2

Fig. 3

Fig. 4

Fig. 5

Fig. 6

Fig. 7

Tensions
$\vec{V}_1, \vec{V}_2, \vec{V}_3$

Acquisition — E1

Traitement — E2

Algorithme
exploratoire — E3

Etude de l'état
connecté /
déconnecté de
chaque ligne

Configuration n°1 — E4

Test ?  O  N — E5
Configuration
retenue

Configuration n°2 — E6

Test ?  O  N  ... — E7
Configuration
retenue

Configuration n°N — EN

Test ?  O  N — EN+1
Configuration
retenue

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- CN 10744997 B